# EUROPEAN PATENT APPLICATION

(11) **EP 4 756 467 A1**
(43) Date of publication of application: **10.06.2026**
(21) Application number: 23947373.9
(22) Date of filing: 29.11.2023
(51) Int. Cl.: G01R 33/09, G01R 33/02, G01R 33/06

(54) **MAGNETIC FIELD SENSOR AND MULTI-AXIS MAGNETIC FIELD SENSOR**

(30) Priority: 01.08.2023 CN 202310960435
(71) Applicant: MultiDimension Technology Co., Ltd., Jiangsu 215634 (CN)
(72) Inventor: LIU, Mingfeng, Jiangsu 215634 (CN); SHI, Ran, Jiangsu 215634 (CN); XUE, Songsheng, Jiangsu 215634 (CN)
(74) Representative: HGF
(86) International application number: PCT/CN2023/134879
(87) International publication number: WO 2025/025435

(57) **Abstract**

The present application provides a magnetic field sensor and a multi-axis magnetic field sensor, and relates to the field of magnetic field measurement technology. The magnetic field sensor comprises: a magnetic flux conversion module, a magnetic induction module, and a differential detection module. The magnetic flux conversion module comprises: a magnetic field input area, a magnetic field output area, a magnetic flux direction conversion area, and a magnetic flux path connection area. The magnetic flux conversion module concentrates and amplifies a magnetic field to be measured in the magnetic field induction direction and converts it into a magnetic field component in a spatial solid angle direction with an angle of 0-90 degrees with the direction of the magnetic field to be measured. The magnetic induction module senses the magnetic field at the air gap of the magnetic flux conversion module, generates a differential voltage signal, and forms an output electrical signal to be measured through the differential detection module. This enables the conversion of the magnetic field to be measured into a magnetic field component in the opposite direction at the air gap, thereby realizing differential detection of a push-pull bridge structure using magnetic induction modules with the same sensitivity direction. It can be manufactured in an integrated manner, leading to a simple process and good sensitivity consistency, and it is easy to produce.

## Description

### Technical Field

The present application relates to the technical field of magnetic field measurement, and more specifically, to a magnetic field sensor and a multi-axis magnetic field sensor.

### Background of the Invention

Magnetic sensors are widely used in modem industry and electronic products to measure physical parameters such as current, position, and direction by sensing changes in magnetic field strength. In the prior art, there are many different types of sensors used to measure magnetic fields and other parameters, such as sensors that use giant magnetoimpedance (GMI), fluxgate, Hall element, and anomalous Hall element (AHE), or sensors that use magnetoresistive sensitive elements such as anisotropic magnetoresistance (AMR), giant magnetoresistance (GMR), tunnel magnetoresistance (TMR), perpendicular tunnel magnetoresistance (PTMR), and colossal magnetoresistance (CMR). The common measurement method of magnetic sensors is to use a bridge structure to perform differential detection to generate a voltage output, and to sense a magnetic field to be measured through differential full bridge, differential half bridge, push-pull full bridge, and push-pull half bridge.

Currently, in order to construct a differential detection structure, the magnetic induction module used by existing sensors usually has two opposite sensitivity directions. The implementation methods thereof comprise: (1) using separate push arm and wrist arm slices, which requires the operation of two slices to be precisely positioned in the same plane, while it is easy to produce angular deviation and zero point offset that affect sensitivity consistency and measurement accuracy. (2) Using a design of a ferromagnetic reference layer with a multilayer thin film structure, which increases the complexity of the microfabrication process because at least two multilayer thin film structures need to be introduced when depositing multilayer thin films. (3) Using a laser-programmed heating magnetic field annealing method, which requires specific equipment, has a complex process, and is costly.

### Summary of the Invention

In view of this, the objective of embodiments of the present application is to provide a magnetic field sensor and a multi-axis magnetic field sensor. The magnetic field sensor comprises: a magnetic flux conversion module, a magnetic induction module, and a differential detection module. The magnetic flux conversion module comprises: a magnetic field input area, a magnetic field output area, a magnetic flux direction conversion area, and a magnetic flux path connection area. The magnetic flux conversion module concentrates and amplifies a magnetic field to be measured in the magnetic field induction direction and converts it into a magnetic field component in a spatial solid angle direction with an angle of 0-90 degrees with the direction of the magnetic field to be measured. The magnetic induction module senses the magnetic field at the air gap of the magnetic flux conversion module, generates a differential voltage signal, and forms an output electrical signal to be measured through the differential detection module. This enables the conversion of the magnetic field to be measured into a magnetic field component in the opposite direction at the air gap, thereby realizing differential detection of a push-pull bridge structure using magnetic induction modules with the same sensitivity direction. It can be manufactured in an integrated manner, leading to a simple process and good sensitivity consistency, and it is easy to produce, thereby solving the problems of existing magnetic field sensors such as complex processes, high costs, and poor sensitivity consistency.

In a first aspect, embodiments of the present application provide a magnetic field sensor, the sensor comprising: a magnetic flux conversion module, a magnetic induction module, and a differential detection module; the differential detection module is electrically connected to the magnetic induction module; the magnetic flux conversion module comprises: a magnetic field input area, a magnetic field output area, a magnetic flux direction conversion area, and a magnetic flux path connection area; the magnetic flux path connection area comprises: at least two air gaps located at different positions; the magnetic induction module comprises: at least two magnetic induction units; the magnetic flux path connection area carries out magnetic path connection on the magnetic field input area, the magnetic field output area, and the magnetic flux direction conversion area, and forms a magnetic flux path that, in the magnetic induction direction, enters the magnetic field input area, exits from the magnetic field output area, and is continuous; the at least two magnetic induction units are correspondingly arranged at the at least two air gaps, and the sensitivity direction of the magnetic induction unit is perpendicular to the vertical projection direction of the air gap; wherein the magnetic flux conversion module is used to guide the magnetic field to be measured along the magnetic induction direction to the magnetic flux path and generate a differential magnetic field component in the air gap of the magnetic flux path; the magnetic induction module is used to generate a differential voltage signal based on the differential magnetic field component; and the differential detection module is used to process the differential voltage signal and output an electrical signal to be measured.

In the above-described implementation process, the magnetic flux conversion module concentrates and amplifies a magnetic field to be measured in the magnetic field induction direction and converts it into a magnetic field component in a spatial solid angle direction with an angle of 0-90 degrees with the direction of the magnetic field to be measured; the magnetic induction module senses the magnetic field at the air gap of the magnetic flux conversion module, generates a differential voltage signal, and forms an output electrical signal to be measured through the differential detection module. This enables the conversion of the magnetic field to be measured into a magnetic field component in the opposite direction at the air gap, thereby realizing differential detection of a push-pull bridge structure using magnetic induction modules with the same sensitivity direction. It can be manufactured in an integrated manner, leading to a simple process and good sensitivity consistency, and it is easy to produce.

Optionally, the magnetic flux conversion module comprises: a magnetic field input area, a magnetic field output area, at least three magnetic flux direction conversion areas, and at least two magnetic flux path connection areas; the at least three magnetic flux direction conversion areas are located in corner areas of the magnetic flux conversion module, and the at least two magnetic flux path connection areas connect adjacent two of the corner areas and form a single continuous magnetic flux path in the magnetic induction direction with the magnetic field input area and the magnetic field output area; wherein the at least two magnetic induction units are used to form a magnetoresistor of a push-pull half-bridge or push-pull full-bridge circuit, and generate a differential voltage signal by sensing the magnetic field to be measured in the magnetic induction direction.

In the above-described implementation process, after subjecting the magnetic field to be measured to concentration and amplification and magnetic circuit distortion, magnetic field components with opposite positive and negative directions are generated at air gaps disposed at two different locations through the same (single) series magnetic flux path, to form a differential magnetic field, and a push-pull half-bridge structure is used to generate a differential voltage signal, and an output electrical signal is formed through an open-loop signal conditioning circuit. The advantage lies in that push-pull half-bridge measurement can be achieved using only magnetic induction units with the same sensitivity direction, thereby avoiding the angle deviation and zero-point offset problems in the prior art that are caused by using different sensitivity directions, and achieving good sensitivity consistency and high measurement accuracy; moreover, the process is simple and low-cost, and it can achieve single-chip integrated manufacturing, and has the characteristics of small size and good stability.

Optionally, the magnetic flux conversion module comprises: a magnetic field input area, a magnetic field output area, at least four magnetic flux direction conversion areas, and at least four magnetic flux path connection areas; the at least four magnetic flux direction conversion areas are located in corner areas of the magnetic flux conversion module, and the at least four magnetic flux path connection areas connect adjacent two of the corner areas and form two continuous magnetic flux paths with the magnetic field input area and the magnetic field output area in the magnetic induction direction; wherein the at least two magnetic induction units are used to form a magnetoresistor of a push-pull half-bridge or push-pull full-bridge circuit, and generate a differential voltage signal by sensing the magnetic field to be measured in the magnetic induction direction.

In the above-described implementation process, by employing a magnetic flux conversion module structure with two single magnetic flux paths in mirror symmetry for parallel superposition, and subjecting the magnetic field to be measured to concentration and amplification and magnetic circuit distortion, two mirror-symmetric magnetic flux paths in parallel are formed, magnetic field components with opposite positive and negative directions are generated at air gaps disposed at four different locations to form a differential magnetic field, and a push-pull full-bridge structure is used to generate a differential voltage signal, and an output electrical signal is formed through an open-loop signal conditioning circuit. Its advantages are that push-pull full-bridge measurement can be achieved using only magnetic induction units in the same sensitivity direction, which can achieve single-chip integrated manufacturing, and can further enhance the magnetic concentrating effect, improve sensitivity, and reduce noise.

Optionally, the magnetic induction module further comprises: a magnetic shielding reference magnetic induction unit; the magnetic shielding reference magnetic induction unit is located within the vertical projection range of the magnetic flux conversion module; wherein the at least two magnetic induction units are used to form a magnetoresistor of a push-pull half-bridge or push-pull full-bridge circuit, and generate a differential voltage signal by sensing the magnetic field to be measured in the magnetic induction direction; or the at least one magnetic induction unit is used to form a magnetoresistor of a push-pull half-bridge or push-pull full-bridge circuit with the magnetic shielding reference magnetic induction unit, and generate a differential voltage signal by sensing the magnetic field to be measured in the magnetic induction direction.

In the above-described implementation process, by partially merging separate soft magnetic metal materials where the two parallel magnetic circuits are at, it is helpful to improve stability and reduce volume. Meanwhile, a magnetic induction unit located within the vertical projection range of the soft magnetic metal material of the magnetic flux conversion module is added as a magnetic shielding reference magnetic induction unit, which can form a differential half-bridge or differential full-bridge structure to sense the magnetic field to be measured, and help to adjust and expand the measurement range of the magnetic field sensor. Among them, the magnetic shielding reference magnetic induction unit and the magnetic induction unit at the air gap projection are distributed adjacently and are both located near the air gap in the magnetic flux path connection area, which helps to enhance consistency and reduce zero-point drift.

Optionally, the magnetic flux conversion module further comprises: a magnetic flux shielding soft magnetic path; the magnetic flux shielding soft magnetic path connects two magnetic flux path connection areas that are arranged opposite each other along the magnetic induction direction among the at least four magnetic flux path connection areas; and the magnetic flux shielding soft magnetic path is used to perform shielding or flux separation on the magnetic flux path connection areas with air gaps.

In the above-described implementation process, by adding a magnetic flux shielding soft magnetic path, the influence of the magnetic field to be measured on the operating range of the magnetic field sensor is addressed, which significantly increases the operating range of the magnetic field sensor under the magnetic field to be measured, and improves the sensitivity consistency of the magnetic induction unit. Meanwhile, the magnetic induction unit that serves as the magnetic shielding reference magnetic induction unit is no longer distributed adjacent to the magnetic induction unit at the air gap projection. Instead, it is located at a position with a large coverage area of soft magnetic metal materials, which improves the magnetic shielding effect and makes its resistance value more stable.

Optionally, the magnetic flux conversion module comprises: at least two magnetic field input areas and at least two magnetic field output areas; the magnetic flux shielding soft magnetic path connects two adjacent magnetic field input areas of the at least two magnetic field input areas, and the magnetic flux shielding soft magnetic path connects two adjacent magnetic field output areas of the at least two magnetic field output areas; and the magnetic flux shielding soft magnetic path is used to perform shielding or flux separation on the magnetic flux path connection areas with air gaps.

In the above-described implementation process, by adding a magnetic flux shielding soft magnetic path, and increasing the distance between the soft magnetic materials at the location of the magnetic induction module, it can further enhance the isolation effect of the magnetic field to be measured and strengthen shielding or flux separation, which addresses the influence of the magnetic field to be measured on the operating range of the magnetic field sensor, significantly increases the operating range of the magnetic field sensor under the magnetic field to be measured, and improves the sensitivity consistency of the magnetic induction module.

Optionally, the magnetic flux conversion module and the magnetic induction module are disposed on the same circuit chip using a chip integration process.

In the above-described implementation process, the cost is reduced by using a single-chip integrated fabrication process to process the magnetic flux conversion module and the magnetic induction unit on the same chip.

Optionally, the soft magnetic materials of any two of the magnetic field input areas, the magnetic field output areas, the magnetic flux direction conversion areas, and the magnetic flux path connection areas are disposed on the same plane.

In the above-described implementation process, by disposing soft magnetic materials of any two parts in the magnetic flux conversion module that constitute the magnetic flux path on the same plane, the technical difficulty is reduced and the needs of more scenarios can be met.

Optionally, the differential detection module comprises: an open-loop signal conditioning circuit; the open-loop signal conditioning circuit is electrically connected with the magnetic induction units; and the open-loop signal conditioning circuit is used to perform conditioning amplification, and/or temperature compensation, and/or linearity correction on the differential voltage signal.

In the above-described implementation process, an open-loop signal conditioning circuit is used for conditioning amplification, temperature compensation, and linearity correction, thereby achieving open-loop detection, improving detection accuracy, and obtaining good linearity.

Optionally, the differential detection module comprises: a closed-loop signal conditioning circuit and a magnetic field feedback coil; the closed-loop signal conditioning circuit is electrically connected to the magnetic induction units; the closed-loop signal conditioning circuit, the magnetic field feedback coil, and the magnetic induction units constitute a closed-loop magnetic field feedback structure; the closed-loop signal conditioning circuit is used to condition and amplify the differential voltage signal; the magnetic field feedback coil is used to generate a feedback magnetic field based on the conditioned and amplified signal to achieve dynamic magnetic field balance, and to sample the current in the magnetic field feedback coil to form the electrical signal to be measured.

In the above-described implementation process, a closed-loop signal conditioning circuit and a magnetic field feedback coil are used for differential detection, thereby achieving closed-loop negative feedback, improving accuracy, and obtaining good linearity.

In a second aspect, embodiments of the present application provide a multi-axis magnetic field sensor, the sensor comprising: a plurality of combined magnetic field sensors of any one of the above; the magnetic flux conversion module in the plurality of combined magnetic field sensors of any one of the above has a plurality of magnetic field induction directions; and the magnetic flux conversion module is used to perform differential detection on the corresponding magnetic field to be measured in any of the magnetic field induction directions.

In the above-described implementation process, by setting up a multi-axis sensor, not only can respective magnetic induction modules and measurement methods of multi-axis directions be flexibly and independently selected, but also the magnetic flux conversion module in any direction has the functions of concentration and amplification and magnetic circuit guiding on the magnetic field to be measured in its own magnetic field induction direction. Therefore, it can perform shielding or flux separation on the magnetic induction modules in other magnetic field induction directions, which can increase the operating range of the magnetic field sensor and improve its flexibility.

### Brief Description of the Accompanying Drawings

In order to more clearly illustrate the technical solutions in the embodiments of the present application, the accompanying drawings required for use in the embodiments of the present application will be briefly introduced below. It should be understood that the drawings below merely illustrate some embodiments of the present application, and thus should not be construed as limitations to the scope. Those skilled in the art may derive other relevant drawings based on these drawings without any creative work.
FIG. 1 is a schematic diagram of the module structure of a magnetic field sensor according to the embodiments of the present application;
FIG. 2 is a partial cross-sectional view of a first type of magnetic field sensor according to the embodiments of the present application;
FIG. 3 is a partial cross-sectional view of a second type of magnetic field sensor according to the embodiments of the present application;
FIG. 4 is a simulation diagram of a magnetic flux path of a magnetic field to be measured in the Y-axis direction applied by the second type of magnetic field sensor according to the embodiments of the present application;
FIG. 5 is a partial cross-sectional view of a third type of magnetic field sensor according to the embodiments of the present application;
FIG. 6 is a simulation diagram of a magnetic flux path of a magnetic field to be measured in the X-axis direction applied by the third type of magnetic field sensor according to the embodiments of the present application;
FIG. 7 is a partial cross-sectional view of a fourth type of magnetic field sensor according to the embodiments of the present application;
FIG. 8 is a partial cross-sectional view of a fifth type of magnetic field sensor according to the embodiments of the present application;
FIG. 9 is a partial cross-sectional view of a sixth type of magnetic field sensor according to the embodiments of the present application;
FIG. 10 is a partial cross-sectional view of a seventh type of magnetic field sensor according to the embodiments of the present application;
FIG. 11 is a simulation diagram of a magnetic flux path of a magnetic field to be measured in the X-axis direction applied by the seventh type of magnetic field sensor according to the embodiments of the present application;
FIG. 12 is a simulation diagram of a magnetic flux path of a magnetic field in the Y-axis direction applied by the seventh type of magnetic field sensor according to the embodiments of the present application;
FIG. 13 is a partial cross-sectional view of an eighth type of magnetic field sensor according to the embodiments of the present application;
FIG. 14 is a simulation diagram of a magnetic flux path of a magnetic field in the Y-axis direction applied by the eighth type of magnetic field sensor according to the embodiments of the present application;
FIG. 15 is a schematic diagram of a voltage-magnetic field curve of tunnel magnetoresistance (TMR) according to the embodiments of the present application;
FIG. 16 is a partial cross-sectional view of a ninth type of magnetic field sensor according to the embodiments of the present application;
FIG. 17 is a schematic diagram of the structure of a first type of multi-axis magnetic field sensor according to the embodiments of the present application;
FIG. 18 is a schematic diagram and three views of the structure of a second type of multi-axis magnetic field sensor according to the embodiments of the present application;
FIG. 19 is a schematic diagram and three views of the structure of a third type of multi-axis magnetic field sensor according to the embodiments of the present application.

Reference numerals: 01-magnetic field sensor; 10-magnetic flux conversion module; 20-magnetic induction module; 30-differential detection module; 02-multi-axis magnetic field sensor.

### Detailed Description of Embodiments

The technical solutions in the embodiments of the present application will be clearly and completely described in conjunction with the accompanying drawings in the embodiments of the present application. Obviously, the described embodiments are merely a part of the embodiments of the present application and are not all embodiments. The components of the embodiments of the present application, which are typically described and illustrated in the accompanying drawings, can be arranged and designed in a variety of different configurations. Therefore, the following detailed description of the embodiments of the present application provided in the accompanying drawings is not intended to limit the claimed scope of the present application, but merely to illustrate the selected embodiments of the present application. Based on the embodiments of the present application, all other embodiments that may be derived by those skilled in the art without making creative efforts shall fall within the scope of protection of the present application.

It should be noted that similar labels and letters in the following figures indicate similar items. Therefore, once an item is defined in one figure, it does not need to be further defined and explained in subsequent figures. The terms "comprising," "comprising," or any other variations thereof are intended to cover non-exclusive inclusion, such that a process, method, article, or apparatus that comprises a list of elements comprises not only those elements but also other elements not expressly listed, or elements inherent to such process, method, article, or apparatus. In the absence of further restrictions, an element defined by the phrase "comprising a..." does not exclude the presence of other identical elements in the process, method, article, or apparatus that comprises said element. The terms "first," "second," etc. are used only to distinguish one entity or operation from another, and do not necessarily require or imply any such actual relationship or order between these entities or operations.

The inventors of the present application note that common measurement methods of magnetic sensors use a bridge structure to perform differential detection to generate a voltage output, and sense a magnetic field to be measured through differential full bridge, differential half bridge, push-pull full bridge, and push-pull half bridge. Among them, the push-pull bridge magnetic sensor has higher sensitivity and lower temperature drift than the differential bridge magnetic sensor that uses a single resistor or a reference resistor. In order to form a differential detection structure, the magnetic induction unit used in existing sensors usually has two opposite sensitivity directions. The implementation methods comprise: (1) using discrete push arm and wrist arm slices and setting them in a specific position, that is, first manufacturing a magnetic induction unit with a single sensitivity direction, and rotating one of the slices relative to the other slice by 180 degrees to form a push arm and wrist arm with opposite sensitivity directions, and then connecting the slices of the push arm and wrist arm in the form of flying wires; its advantage is that the preparation method is simple and the cost is low, but the disadvantage is that it is necessary to operate the two slices to be precisely positioned in the same plane, which is easy to produce angular deviation and zero point offset, affecting the sensitivity consistency and measurement accuracy. (2) Using the design of a ferromagnetic reference layer with a multilayer thin film structure, which can realize the manufacturing of push-magnetoresistive sensing units and pull-magnetoresistive sensing units of opposite ferromagnetic reference layers by changing the number of layers of the multilayer thin film composed of the ferromagnetic layer and the metal spacer layer that are interactively coupled with an antiferromagnetic layer, one being an odd numbered layer and the other being an even numbered layer. The disadvantage is that the complexity of the microfabrication process is increased because at least two multilayer thin film structures need to be introduced when depositing multilayer thin films. (3) Using a method of laser-programmed heating magnetic field annealing to scan the magnetoresistive sensing unit and quickly heat the anti-ferromagnetic layer to above the blocking temperature. At the same time, a magnetic field can be applied in any direction during the cooling process, which is scanned one by one to realize the orientation of the magnetoresistive sensing unit in any magnetic field sensitive direction. This method can realize the manufacturing of four types of magnetoresistive sensing units with orthogonal orientation and their arrays of biaxial magnetoresistive sensing units on a single slice. However, the disadvantage is that it requires specific equipment, the process is complicated, and the cost is high. In addition, to improve the sensitivity of magnetic sensors and reduce noise, a soft magnetic flux concentrator can be further used to concentrate and amplify the magnetic field to be measured to enhance the signal output. At the same time, the soft magnetic flux concentrator also has the effect of distorting the direction of the magnetic field to be measured. In view of this, embodiments of the present application provide a magnetic field sensor 01 and a multi-axis magnetic field sensor 02, as described below.

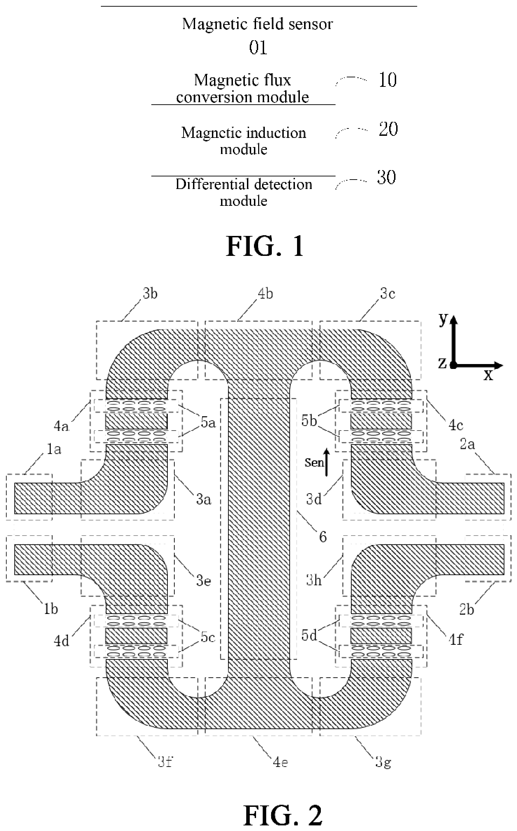

Refer to FIG. 1, which is a schematic diagram of the module structure of the magnetic field sensor 01 according to the embodiments of the present application. The embodiments of the present application will be explained in detail below. The sensor comprises: a magnetic flux conversion module 10, a magnetic induction module 20, and a differential detection module 30; the magnetic flux conversion module 10 comprises: a magnetic field input area, a magnetic field output area, a magnetic flux direction conversion area, and a magnetic flux path connection area; the magnetic flux path connection area comprises: at least two air gaps located at different positions; the magnetic induction module 20 comprises: at least two magnetic induction units;
the differential detection module 30 is electrically connected to the magnetic induction module 20; the magnetic flux path connection area carries out magnetic path connection on the magnetic field input area, the magnetic field output area, and the magnetic flux direction conversion area, and forms a magnetic flux path that, in the magnetic induction direction, enters the magnetic field input area, exits from the magnetic field output area, and is continuous; the at least two magnetic induction units are correspondingly arranged at the at least two air gaps, and the sensitivity direction of the magnetic induction unit is perpendicular to the vertical projection direction of the air gap; wherein the magnetic flux conversion module 10 is used to guide the magnetic field to be measured along the magnetic induction direction to the magnetic flux path and generate a differential magnetic field component in the air gap of the magnetic flux path; the magnetic induction module 20 is used to generate a differential voltage signal based on the differential magnetic field component; and the differential detection module 30 is used to process the differential voltage signal and output an electrical signal to be measured.

For example, the magnetic flux conversion module 10 may be constructed using a high-permeability soft magnetic material, the magnetic flux path of the magnetic flux conversion module 10 is formed by the magnetic guiding effect of the high-permeability soft magnetic material, and the magnetic field to be measured in the magnetic field induction direction will undergo a magnetic field direction conversion after passing through the magnetic flux path; the magnetic flux conversion module 10 may specifically comprise a magnetic field input area, a magnetic field output area, a magnetic flux direction conversion area, and a magnetic flux path connection area, the magnetic flux path connection area magnetically carries out magnetic path connection on the soft magnetic flux paths of the magnetic field input area, the magnetic field output area, and the magnetic flux direction conversion area; in the magnetic field induction direction, the magnetic flux path is parallel to the plane of the magnetic flux conversion module 10, enters the magnetic field input area, and exits from the magnetic field output area, and when the magnetic field direction is converted, the magnetic flux path in the magnetic flux direction conversion area and the magnetic flux path connection area is at a spatial solid angle of 0-90 degrees with the magnetic field to be measured; the magnetic flux direction conversion area and/or the magnetic flux path connection area is provided with one or more air gaps, the air gaps intersect with the magnetic field direction of the magnetic flux direction conversion area and/or the magnetic flux path connection area, the magnetic flux path formed by the air gaps and the magnetic flux path formed by the soft magnetic material jointly constitute the magnetic flux path of the magnetic flux direction conversion area and/or the magnetic flux path connection area, and the magnetic circuit direction of the magnetic flux path connection area is perpendicular to the air gaps. The number of the magnetic field input area can be one or more, the number of the magnetic field output area can be one or more, the number of the magnetic flux direction conversion area can be one or more, and the number of the magnetic flux path connection area can be one or more; the magnetic field input area and the magnetic field output area are independent of each other or form a series-parallel magnetic circuit connection, and the magnetic flux direction conversion areas have the same or different structures. The magnetic induction module 20 can be: two or more giant magnetoimpedance (GMI), fluxgates, Hall elements, anomalous Hall elements (AHE), or magnetoresistive sensitive elements (magnetic induction units) whose vertical projection is located at the air gap position of the magnetic flux conversion module 10; for the magnetoresistive sensitive elements, the magnetic induction module 20 can be composed of one or more magnetoresistive sensitive elements connected in series and parallel, and the magnetoresistive sensitive elements are one of anisotropic magnetoresistance (AMR), giant magnetoresistance (GMR), tunnel magnetoresistance (TMR), perpendicular tunnel magnetoresistance (PTMR), and colossal magnetoresistance (CMR). The differential detection module 30 may be an open-loop signal conditioning circuit or a closed-loop signal conditioning circuit, which performs conditioning amplification, temperature compensation, and linearity correction on the differential voltage signal to form an output electrical signal to be measured of the magnetic field sensor 01.

Optionally, as shown in FIG. 2, the magnetic field sensor 01 comprises a magnetic flux conversion module 10, a magnetic induction module 20, and a differential detection module 30. In the magnetic field sensor 01, the magnetic flux conversion module 10 has a single-plane single magnetic field induction direction, and the magnetic field induction direction is the same as that of the magnetic flux conversion module 10, which is the X-axis direction. The magnetic flux conversion module 10 can be configured as follows: two magnetic field input areas 1a and 1b, two magnetic field output areas 2a and 2b, eight magnetic flux direction conversion areas 3a, 3b, 3c, 3d, 3e, 3f, 3g, 3h, and six magnetic flux path connection areas 4a, 4b, 4c, 4d, 4e, 4f, as shown in the embodiment of FIG. 2, and can be supplemented with a magnetic flux shielding soft magnetic path 6; the magnetic induction module 20 can be configured as follows: four magnetic induction units 5a, 5b, 5c, 5d, all of which have the positive Y-axis direction as the sensitivity direction, and the vertical projections of the magnetic induction units 5a, 5b, 5c, 5d are located at the air gaps of the magnetic flux path connection areas 4a, 4c, 4d, 4f of the magnetic flux conversion module 10, respectively. The soft magnetic metal material constituting the magnetic flux conversion module 10 is distributed in the XY plane, which is described by taking the magnetic field to be measured being in the positive X-axis direction as an example; in this case, the magnetic field input areas 1a and 1b are located at the end of the negative X-axis direction, and the magnetic field output areas 2a and 2b are located at the end of the positive X-axis direction; the magnetic flux direction conversion areas 3a and 3g are corners pointing to the negative X-axis direction and the positive Y-axis direction, the magnetic flux direction conversion areas 3b and 3h are corners pointing to the positive X-axis direction and the negative Y-axis direction, the magnetic flux direction conversion areas 3c and 3e are corners pointing to the negative X-axis direction and the negative Y-axis direction, and the magnetic flux direction conversion areas 3d and 3f are corners pointing to the positive X-axis direction and the positive Y-axis direction. The magnetic flux path connection area 4a connects to the magnetic flux direction conversion areas 3a and 3b in the Y-axis direction, the magnetic flux path connection area 4b comprises three ports pointing to the positive X-axis direction, the negative X-axis direction, and the negative Y-axis direction, the magnetic flux path connection area 4c connects to the magnetic flux direction conversion areas 3c and 3d in the Y-axis direction, the magnetic flux path connection area 4d connects to the magnetic flux direction conversion areas 3e and 3f in the Y-axis direction, the magnetic flux path connection area 4e comprises three ports pointing to the positive X-axis direction, the negative X-axis direction, and the positive Y-axis direction, and the magnetic flux path connection area 4f connects to the magnetic flux direction conversion areas 3g and 3h in the Y-axis direction; the magnetic flux shielding soft magnetic path 6 connects to the magnetic flux path connection areas 4b and 4e in the Y-axis direction, and the magnetic flux path connection areas 4a, 4c, 4d, and 4f are each provided with two air gaps in the X-axis direction that penetrate the soft magnetic metal material.

The magnetic field to be measured is concentrated and amplified by the soft magnetic metal material of the magnetic flux conversion module 10 to form a magnetic circuit, and is divided into two sides and twisted to the positive Y-axis direction and the negative Y-axis direction to form two parallel magnetic flux paths, and subsequently, the two magnetic circuits are respectively twisted in opposite directions in the Y-axis direction and then twisted back to the positive X-axis direction. The magnetic field to be measured generates a magnetic field component in the positive Y-axis direction at the air gaps in the magnetic flux path connection areas 4a and 4f, and a magnetic field component in the negative Y-axis direction at the air gaps in the magnetic flux path connection areas 4c and 4d, thereby enabling the formation of a differential magnetic field. Since the sensitivity directions of the magnetic induction units 5a, 5b, 5c, and 5d are all in the positive Y-axis direction, the resistance values of the magnetic induction units 5a and 5d decrease, while the resistance values of the magnetic induction units 5b and 5c increase. Therefore, series and parallel magnetic induction units 5a, 5b, 5c, and 5d can be selected to form a push-pull half-bridge or push-pull full-bridge structure to sense a magnetic field in the positive X-axis direction and generate a differential voltage signal. An open-loop signal conditioning circuit may be employed to perform conditioning amplification, temperature compensation, and linearity correction on the differential voltage signal to form an output electrical signal of the magnetic field sensor 01. In particular, when the magnetic field to be measured is in the positive Y-axis direction, the magnetic flux shielding soft magnetic path 6 can concentrate and guide the magnetic field in the Y-axis direction, thereby achieving the shielding or flux separation effect on the magnetic flux path connection areas with air gaps.

The magnetic flux conversion module 10 and its magnetic field sensor 01 of the present application are applicable to both magnetic induction units with a sensitivity direction parallel to the plane in which they are located and magnetic induction units with a sensitivity direction perpendicular to the plane in which they are located. The magnetic induction units used can be Hall elements whose sensitivity direction (the direction pointed to by the "Sen" arrow in FIG. 2) is perpendicular to the plane in which they are located. In this case, the Hall elements are located in the XZ plane, and their sensitivity direction is the positive Y-axis direction. Other magnetic induction units with the sensitivity direction perpendicular to the plane in which they are located, such as perpendicular tunnel magnetoresistance (PTMR), can adopt a similar structure and are fixed perpendicularly to the air gap of the magnetic flux conversion module 10 located in the XY plane along the XZ plane to form the magnetic field sensor 01. The magnetic induction units used can also be tunnel magnetoresistance (TMR) whose sensitivity direction (the direction pointed to by the "Sen" arrow in FIG. 2) is parallel to the plane in which they are located. In this case, the tunnel magnetoresistance (TMR) is located in the XZ plane, and its sensitivity direction is the positive Y-axis direction. Other magnetic induction units with the sensitivity direction perpendicular to the plane in which they are located, such as giant magnetoresistance (GMR), can adopt a similar structure, and the magnetic induction units are arranged in parallel to the plane in which the magnetic flux conversion module 10 is located to form the magnetic field sensor 01.

The magnetic flux conversion module 10 concentrates and amplifies a magnetic field to be measured in the magnetic field induction direction and converts it into a magnetic field component in a spatial solid angle direction with an angle of 0-90 degrees with the direction of the magnetic field to be measured; the magnetic induction module 20 senses the magnetic field at the air gap of the magnetic flux conversion module 10, generates a differential voltage signal, and forms an output electrical signal to be measured through the differential detection module 30. This enables the conversion of the magnetic field to be measured into a magnetic field component in the opposite direction at the air gap, thereby realizing differential detection of a push-pull bridge structure using magnetic induction modules 20 with the same sensitivity direction. It can be manufactured in an integrated manner, leading to a simple process and good sensitivity consistency, and it is easy to produce.

In one embodiment, the magnetic flux conversion module 10 comprises: a magnetic field input area, a magnetic field output area, at least three magnetic flux direction conversion areas, and at least two magnetic flux path connection areas; the at least three magnetic flux direction conversion areas are located in corner areas of the magnetic flux conversion module 10, and the at least two magnetic flux path connection areas connect adjacent two of the corner areas and form a single continuous magnetic flux path in the magnetic induction direction with the magnetic field input area and the magnetic field output area; wherein the at least two magnetic induction units are used to form a magnetoresistor of a push-pull half-bridge or push-pull full-bridge circuit, and generate a differential voltage signal by sensing the magnetic field to be measured in the magnetic induction direction.

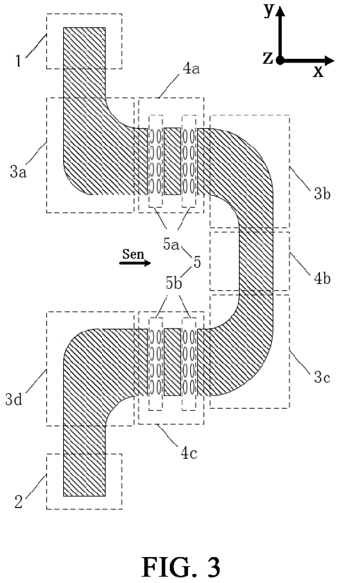

For example, as shown in FIG. 3, the magnetic field sensor 01 comprises a magnetic flux conversion module 10, a magnetic induction module 20, and a differential detection module 30, and the magnetic field induction direction of the magnetic field sensor 01 is the same as that of the magnetic flux conversion module 10, which is the Y-axis direction. The magnetic flux conversion module 10 is a single-plane, single-field-induction-direction structure made of a high-permeability soft magnetic metal material, which may comprise: a magnetic field input area 1, a magnetic field output area 2, four magnetic flux direction conversion areas 3a, 3b, 3c, and 3d, and three magnetic flux path connection areas 4a, 4b, and 4c. Together, they form a single continuous magnetic flux path along the magnetic field induction direction (Y-axis direction), and the soft magnetic metal material constituting the magnetic flux conversion module 10 can be distributed in the XY plane, which will be described by taking the magnetic field to be measured being in the negative Y-axis direction as an example. The magnetic induction module 20 may comprise a magnetic induction unit 5a and a magnetic induction unit 5b. The sensitivity directions of the magnetic induction units 5a and 5b are both in the positive X-axis direction, the vertical projection of the magnetic induction unit 5a is located at the air gap position of the magnetic flux path connection area 4a of the magnetic flux conversion module 10, and the vertical projection of the magnetic induction unit 5b is located at the air gap position of the aforementioned magnetic flux path connection area 4c of the magnetic flux conversion module 10. Therefore, the sensitivity direction of the magnetic induction unit 5 is perpendicular to the air gap in which it is located. In this case, the magnetic field input area 1 and the magnetic field output area 2 are located at the end of the positive Y-axis direction and the end of the negative Y-axis direction, respectively; the magnetic flux direction conversion area 3a is a corner pointing to the positive X-axis direction and the positive Y-axis direction, the magnetic flux direction conversion area 3b is a corner pointing to the negative X-axis direction and the negative Y-axis direction, the magnetic flux direction conversion area 3c is a corner pointing to the negative X-axis direction and the positive Y-axis direction, and the magnetic flux direction conversion area 3d is a corner pointing to the positive X-axis direction and the negative Y-axis direction; the magnetic flux path connection area 4a connects to the magnetic flux direction conversion areas 3a and 3b in the X-axis direction, the magnetic flux path connection area 4b connects to the magnetic flux direction conversion areas 3b and 3c in the Y-axis direction, the magnetic flux path connection area 4c connects to the magnetic flux direction conversion areas 3c and 3d in the X-axis direction, and the magnetic flux path connection areas 4a and 4c are each provided with two air gaps in the Y-axis direction that penetrate the soft magnetic metal material.

When the magnetic field to be measured is in the negative Y-axis direction, the soft magnetic metal material concentrates and amplifies the magnetic field to be measured and forms a magnetic flux path, which enters the magnetic field input area 1 at the end of the positive Y-axis direction, and is then twisted to the positive X-axis direction by the magnetic flux direction conversion area 3a; subsequently, it passes through the magnetic flux path connection area 4a with an air gap along the positive X-axis direction, and generates a magnetic field component in the positive X-axis direction in the air gap; this magnetic path then passes through the magnetic flux direction conversion area 3b, the magnetic flux path connection area 4b, and the magnetic flux direction conversion area 3c in sequence, and after the magnetic path is twisted reversely from the positive X-axis direction to the negative X-axis direction, it then passes through the magnetic flux path connection area 4c with an air gap, and generates a magnetic field component in the negative X-axis direction in the air gap; thus, the magnetic field to be measured in the Y-axis direction can generate opposite magnetic field components in the positive and negative X-axis directions in air gaps at different positions to form a differential magnetic field. In order to achieve symmetry in the measurement of magnetic field in the positive and negative directions of the Y-axis, the magnetic circuit is twisted back to the negative Y-axis direction by the magnetic flux path conversion area 3d after passing through the magnetic flux direction connection area 4c, and then passes through the magnetic field output area 2. Among them, the magnetic field input area 1 and the magnetic field output area 2 are completely equivalent and can be interchanged according to the change of the direction of the magnetic field to be measured; that is, for the same soft magnetic metal material structure, the magnetic field input area 1 and the magnetic field output area 2 are only used to indicate and describe the direction of the magnetic field to be measured entering and exiting the magnetic flux conversion module 10; when the magnetic field to be measured is reversed, it can be regarded as the original magnetic field input area 1 and magnetic field output area 2 being interchanged. Furthermore, although the magnetic flux path connection area carries out magnetic path connection on the soft magnetic flux paths of the magnetic field input area 1, the magnetic field output area 2, and the magnetic flux direction conversion area, the actual definition of the magnetic flux path connection area may vary for the same soft magnetic metal material structure; for example, in FIG. 3, the magnetic field input area 1 and the magnetic flux direction conversion area 3a are defined as directly connected, or they can be defined as having a section of magnetic flux path connection area; similarly, in FIG. 3, the magnetic flux direction conversion area 3b, the magnetic flux path connection area 4b, and the magnetic flux direction conversion area 3c are connected in sequence, and when the corner distance between the magnetic flux direction conversion areas 3b and 3c is too close, they can be considered as directly connected; likewise, the part of the soft magnetic metal material with an air gap can be considered as being located in the magnetic flux path connection area or in the magnetic flux direction conversion area.

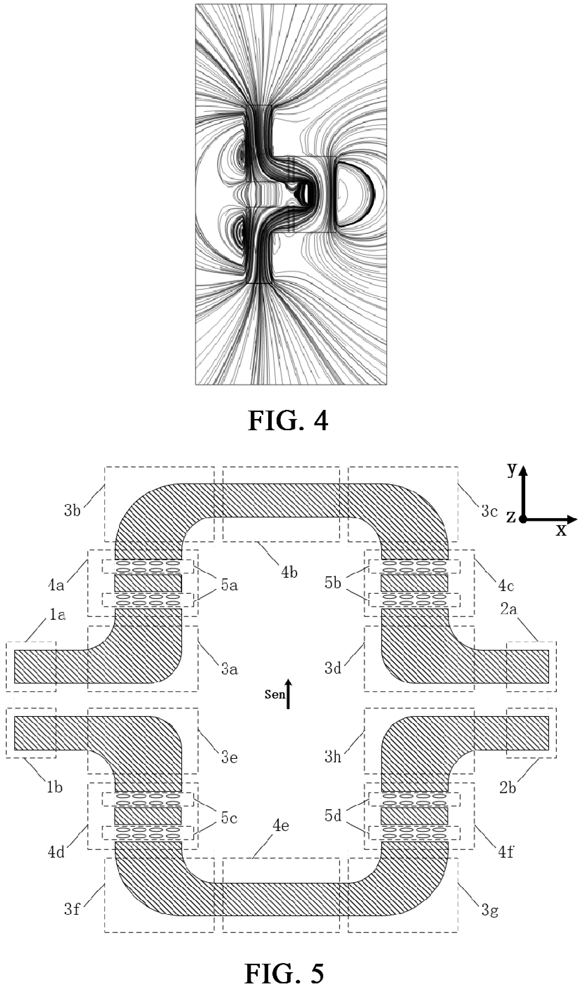

As shown in FIG. 4, from the simulation diagram of a magnetic flux path after a magnetic field to be measured in the negative Y-axis direction is applied to the magnetic flux conversion module 10 in the embodiment of FIG. 3, it can be seen that the magnetic field to be measured is concentrated and amplified by the soft magnetic metal material to form a magnetic circuit, and magnetic flux offset within a spatial solid angle of 0-90 degrees occurs sequentially at the magnetic flux direction conversion areas 3a, 3b, 3c, and 3d, and it can be seen that obvious opposite magnetic field components in the positive and negative X-axis directions can be generated at the air gaps in the magnetic flux path connection areas 4a and 4c to form a differential magnetic field, and the magnetic flux paths through the air gaps are connected in series. Similarly, by taking the magnetic field to be measured being in the negative Y-axis as an example, the magnetic circuit that has been concentrated and amplified passes through the magnetic flux path connection area 4a with an air gap along the positive X-axis direction, and then passes through the magnetic flux path connection area 4c with an air gap along the negative X-axis direction; at this moment, a magnetic field component in the positive X-axis direction is generated in the air gap of the magnetic flux path connection area 4a, and a magnetic field component in the negative X-axis direction is generated in the air gap of the magnetic flux path connection area 4c. Since the sensitivity directions of the magnetic induction units 5a and 5b are both in the positive X-axis direction, the resistance value of the magnetic induction unit 5a decreases, while the resistance value of the magnetic induction unit 5b increases. Therefore, a push-pull half-bridge structure can be employed to sense a magnetic field in the negative Y-axis direction and generate a differential voltage signal. An open-loop signal conditioning circuit may be employed to perform conditioning amplification, temperature compensation, and linearity correction on the differential voltage signal to form an output electrical signal to be measured of the magnetic field sensor 01.

Depending on the placement position and orientation, the magnetic induction unit 5 may adopt giant magnetoimpedance (GMI), fluxgates, Hall elements, anomalous Hall elements (AHE), or magnetoresistive sensitive elements, wherein the magnetoresistive sensitive elements may be one or more anisotropic magnetoresistance (AMR), giant magnetoresistance (GMR), tunnel magnetoresistance (TMR), perpendicular tunnel magnetoresistance (PTMR), and colossal magnetoresistance (CMR) that are connected in series and parallel. Specifically, when the sensitivity direction of the magnetic induction unit 5 is perpendicular to its own plane, the substrate where the magnetic induction unit 5 is located is perpendicular to the plane in which the magnetic flux conversion module 10 is located. For example, if the magnetic flux conversion module 10 shown in FIG. 1 and located in the XY plane is measured by using Hall elements as an example, the substrate of each Hall element is respectively parallel to the YZ plane, and then it is connected and fixed through basic components such as substrates, lead pads, mechanical support housing, etc. When the sensitivity direction of the magnetic induction unit 5 is parallel to its own plane, the substrate where it is located is parallel to the plane where the magnetic flux conversion module 10 is located. Since all magnetic induction units can form a differential bridge or push-pull bridge using only the sensitivity in the same direction, when using a magnetoresistive sensitive element with the sensitivity direction parallel to its own plane, such as tunnel magnetoresistive (TMR), a magnetoresistive thin film can be fabricated on the same layer at once, and in combination with the substrate, lead pads, and mechanical support housing, single-chip fabrication can be achieved.

After subjecting the magnetic field to be measured to concentration and amplification and magnetic circuit distortion, magnetic field components with opposite positive and negative directions are generated at air gaps disposed at two different locations through the same (single) series magnetic flux path, to form a differential magnetic field, and a push-pull half-bridge structure is used to generate a differential voltage signal, and an output electrical signal is formed through an open-loop signal conditioning circuit. The advantage lies in that push-pull half-bridge measurement can be achieved using only magnetic induction units 5 with the same sensitivity direction, thereby avoiding the angle deviation and zero-point offset problems in the prior art that are caused by using different sensitivity directions, and achieving good sensitivity consistency and high measurement accuracy; moreover, the process is simple and low-cost, and it can achieve single-chip integrated manufacturing, and has the characteristics of small size and good stability.

In one embodiment, the magnetic flux conversion module 10 comprises: a magnetic field input area, a magnetic field output area, at least four magnetic flux direction conversion areas, and at least four magnetic flux path connection areas; the at least four magnetic flux direction conversion areas are located in corner areas of the magnetic flux conversion module 10, and the at least four magnetic flux path connection areas connect two adjacent corner areas and form two continuous magnetic flux paths in the magnetic induction direction with the magnetic field input area and the magnetic field output area; wherein the at least two magnetic induction units are used to form a magnetoresistor of a push-pull half-bridge or push-pull full-bridge circuit, and generate a differential voltage signal by sensing the magnetic field to be measured in the magnetic induction direction.

For example, as shown in FIG. 5, the magnetic field sensor 01 comprises a magnetic flux conversion module 10, a magnetic induction module 20, and a differential detection module 30, and the magnetic field induction direction of the magnetic field sensor 01 is the same as that of the magnetic flux conversion module 10, which is the X-axis direction. The magnetic flux conversion module 10 is equivalent to parallel superposition of the structures of the two magnetic flux conversion modules 10 in FIG. 3 in mirror-symmetry, and the magnetic flux conversion module 10 is a single-plane single magnetic field induction direction, which can specifically comprise: two magnetic field input areas 1a and 1b, two magnetic field output areas 2a and 2b, eight magnetic flux direction conversion areas 3a, 3b, 3c, 3d, 3e, 3f, 3g, 3h, and six magnetic flux path connection areas 4a, 4b, 4c, 4d, 4e, 4f. Together, they constitute two continuous magnetic flux paths along the magnetic field induction direction (X-axis direction). The magnetic induction module 20 may comprise four magnetic induction units 5a, 5b, 5c, 5d, the sensitivity directions of the magnetic induction units 5a, 5b, 5c, 5d are all in the positive Y-axis direction, and the vertical projections of the magnetic induction units 5a, 5b, 5c, 5d are respectively located at the air gaps of the magnetic flux path connection area 4a, 4c, 4d, 4f of the magnetic flux conversion module 10. Therefore, the sensitivity direction of the magnetic induction unit 5 is perpendicular to the air gap in which it is located. The soft magnetic metal material constituting the magnetic flux conversion module 10 is distributed in the XY plane, which is described by taking the magnetic field to be measured being in the positive X-axis direction as an example; in this case, the magnetic field input areas 1a and 1b are located at the end of the negative X-axis direction, and the magnetic field output areas 2a and 2b are located at the end of the positive X-axis direction. The magnetic flux direction conversion areas 3a and 3g are corners pointing to the negative X-axis direction and the positive Y-axis direction, the magnetic flux direction conversion areas 3b and 3h are corners pointing to the positive X-axis direction and the negative Y-axis direction, the magnetic flux direction conversion areas 3c and 3e are corners pointing to the negative X-axis direction and the negative Y-axis direction, and the magnetic flux direction conversion areas 3d and 3f are corners pointing to the positive X-axis direction and the positive Y-axis direction. The magnetic flux path connection area 4a connects to the magnetic flux direction conversion areas 3a and 3b in the Y-axis direction, the magnetic flux path connection area 4b connects to the magnetic flux direction conversion areas 3b and 3c in the X-axis direction, the magnetic flux path connection area 4c connects to the magnetic flux direction conversion areas 3c and 3d in the Y-axis direction, the magnetic flux path connection area 4d connects to the magnetic flux direction conversion areas 3e and 3f in the Y-axis direction, the magnetic flux path connection area 4e connects to the magnetic flux direction conversion areas 3f and 3g in the X-axis direction, and the magnetic flux path connection area 4f connects to the magnetic flux direction conversion areas 3g and 3h in the Y-axis direction; and among them, the magnetic flux path connection areas 4a, 4c, 4d, and 4f are each provided with two air gaps in the X-axis direction that penetrate the soft magnetic metal material.

When the magnetic field to be measured is in the positive X-axis direction, the soft magnetic metal material concentrates and amplifies the magnetic field to be measured and forms two magnetic flux paths connected in parallel that are mirror-symmetrical about the X-axis. One of the magnetic paths enters the magnetic field input area 1a at the end of the negative Y-axis direction, and is then twisted to the positive Y-axis direction by the magnetic flux direction conversion area 3a; subsequently, it passes through the magnetic flux path connection area 4a with an air gap along the positive Y-axis direction, and generates a magnetic field component in the positive Y-axis direction in the air gap; this magnetic path then passes through the magnetic flux direction conversion area 3b, the magnetic flux path connection area 4b, and the magnetic flux direction conversion area 3c in sequence, and after the magnetic path is twisted reversely from the positive Y-axis direction to the negative Y-axis direction, it then passes through the magnetic flux path connection area 4c with an air gap, and generates a magnetic field component in the negative Y-axis direction in the air gap; thus, the magnetic field to be measured in the X-axis direction can generate opposite magnetic field components in the positive and negative Y-axis directions in air gaps at different positions to form a differential magnetic field. In order to achieve symmetry in the measurement of magnetic field in the positive and negative X-axis directions, the magnetic path is twisted back to the positive X-axis direction by the magnetic flux path conversion area 3d after passing through the magnetic flux direction connection area 4c, and then passes through the magnetic field output area 2a. Similarly, the other magnetic path enters the magnetic field input area 1b at the end of the negative X-axis direction, and is then twisted to the negative Y-axis direction by the magnetic flux direction conversion area 3e; subsequently, it passes through the magnetic flux path connection area 4d with an air gap along the negative Y-axis direction, and generates a magnetic field component in the negative Y-axis direction in the air gap; this magnetic path then passes through the magnetic flux direction conversion area 3f, the magnetic flux path connection area 4e, and the magnetic flux direction conversion area 3g in sequence, and after the magnetic path is twisted reversely from the negative Y-axis direction to the positive Y-axis direction, it then passes through the magnetic flux path connection area 4f with an air gap, and generates a magnetic field component in the positive Y-axis direction in the air gap; thus, the magnetic field to be measured in the X-axis direction can generate opposite magnetic field components in the positive and negative Y-axis directions in air gaps at different positions to form a differential magnetic field; after passing through the magnetic flux path connection area 4f, the magnetic path is twisted back to the positive X-axis direction by the magnetic flux path conversion area 3h, and then passes through the magnetic field output area 2a.

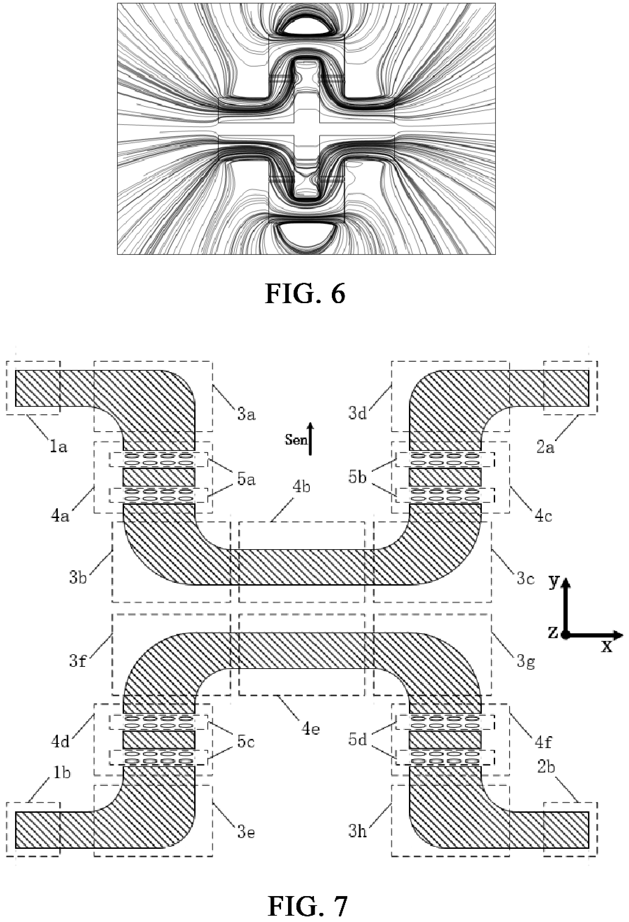

As shown in FIG. 6, from the simulation diagram of a magnetic flux path after a magnetic field to be measured in the positive X-axis direction is applied to the magnetic flux conversion module 10 in the embodiment of FIG. 5, it can be seen that the magnetic field to be measured is concentrated and amplified by the soft magnetic metal material to form a magnetic circuit, and magnetic flux offset within a spatial solid angle of 0-90 degrees occurs sequentially at the magnetic flux direction conversion areas 3a, 3b, 3c, and 3d and at the magnetic flux direction conversion areas 3e, 3f, 3g, and 3h, and it can be seen that an obvious magnetic field component in the positive Y-axis direction can be generated at the air gaps in the magnetic flux path connection areas 4a and 4f, and an obvious magnetic field component in the negative Y-axis direction can be generated at the air gaps in the magnetic flux path connection areas 4c and 4d, thereby enabling the formation of a differential magnetic field, and the magnetic flux paths through the air gaps are two magnetic flux paths connected in parallel that are mirror-symmetrical about the X-axis. One of the magnetic circuits that have been concentrated and amplified passes through the magnetic flux path connection area 4a with an air gap along the positive Y-axis direction, and then passes through the magnetic flux path connection area 4c with an air gap along the negative Y-axis direction; the other magnetic circuit passes through the magnetic flux path connection area 4d with an air gap along the negative Y-axis direction, and then passes through the magnetic flux path connection area 4f with an air gap along the positive Y-axis direction; at this moment, the magnetic field component in the positive Y-axis direction is generated in the air gaps of the magnetic flux path connection areas 4a and 4f, and the magnetic field component in the negative Y-axis direction is generated in the air gaps of the magnetic flux path connection areas 4c and 4d. Since the sensitivity directions of the magnetic induction units 5a, 5b, 5c, 5d are all in the positive Y-axis direction, the resistance values of the magnetic induction units 5a and 5d decrease, while the resistance values of the magnetic induction units 5b and 5c increase. Therefore, a push-pull full-bridge structure can be employed to sense a magnetic field in the positive X-axis direction and generate a differential voltage signal. An open-loop signal conditioning circuit may be employed to perform conditioning amplification, temperature compensation, and linearity correction on the differential voltage signal to form an output electrical signal to be measured of the magnetic field sensor 01.

Optionally, FIG. 7 shows a schematic diagram of another structure of the magnetic flux conversion module 10 and its magnetic field sensor 01 in mirror symmetry about the X-axis. The measurement principle of this structure is basically the same as that of the structure shown in FIG. 5, which is also equivalent to the parallel superposition of the structures of the two magnetic flux conversion modules 10 in FIG. 3 in mirror-symmetry, except that the superposition position is translated and exchanged in the Y-axis direction. The measurement principle will not be described again. Assuming the magnetic field to be measured is in the positive X-axis direction, the magnetic circuit on the side of the positive Y-axis direction passes sequentially through the magnetic field input area 1a, the magnetic flux direction conversion area 3a, the magnetic flux path connection area 4a, the magnetic flux direction conversion area 3b, the magnetic flux path connection area 4b, the magnetic flux direction conversion area 3c, the magnetic flux path connection area 4c, the magnetic flux direction conversion area 3d, and the magnetic field output area 2a; the magnetic circuit on the side of the negative Y-axis direction passes sequentially through the magnetic field input area 1b, the magnetic flux direction conversion area 3e, the magnetic flux path connection area 4d, the magnetic flux direction conversion area 3f, the magnetic flux path connection area 4e, the magnetic flux direction conversion area 3g, the magnetic flux path connection area 4f, the magnetic flux direction conversion area 3h, and the magnetic field output area 2b; and the vertical projections of the magnetic induction units 5a, 5b, 5c, and 5d are located at the air gaps of the magnetic flux path connection areas 4a, 4c, 4d, and 4f, respectively.

By employing a magnetic flux conversion module 10 structure with two single magnetic flux paths in mirror symmetry for parallel superposition, and subjecting the magnetic field to be measured to concentration and amplification and magnetic circuit distortion, two mirror-symmetric magnetic flux paths in parallel are formed, magnetic field components with opposite positive and negative directions are generated at air gaps disposed at four different locations to form a differential magnetic field, and a push-pull full-bridge structure is used to generate a differential voltage signal, and an output electrical signal is formed through an open-loop signal conditioning circuit. Its advantages are that push-pull full-bridge measurement can be achieved using only magnetic induction units in the same sensitivity direction, thereby enabling single-chip integrated manufacturing and further enhancing the magnetic concentrating effect, improving sensitivity, and reducing noise.

In one embodiment, the magnetic induction module 20 further comprises: a magnetic shielding reference magnetic induction unit; the magnetic shielding reference magnetic induction unit is located within the vertical projection range of the magnetic flux conversion module 10; wherein at least two magnetic induction units are used to form a magnetoresistor of a push-pull half-bridge or push-pull full-bridge circuit, and generate a differential voltage signal by sensing the magnetic field to be measured in the magnetic induction direction; or at least one magnetic induction unit is used to form a magnetoresistor of a push-pull half-bridge or push-pull full-bridge circuit with the magnetic shielding reference magnetic induction unit, and generate a differential voltage signal by sensing the magnetic field to be measured in the magnetic induction direction.

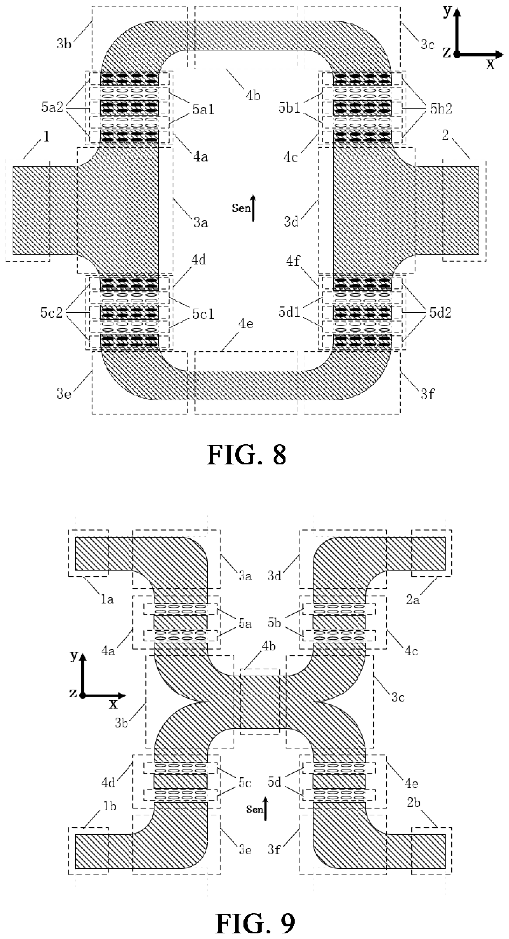

For example, as shown in FIG. 8, the magnetic field sensor 01 comprises a magnetic flux conversion module 10, a magnetic induction module 20, and a differential detection module 30, and the magnetic field induction direction of the magnetic field sensor 01 is the same as that of the magnetic flux conversion module 10, which is the X-axis direction. The magnetic flux conversion module 10 is a single-plane single magnetic field induction direction, which can comprise: one magnetic field input area 1, one magnetic field output area 2, six magnetic flux direction conversion areas 3a, 3b, 3c, 3d, 3e, 3f, and six magnetic flux path connection areas 4a, 4b, 4c, 4d, 4e, 4f. Together, they constitute two continuous magnetic flux paths along the magnetic field induction direction (X-axis direction). The magnetic induction module 20 may comprise magnetic induction units 5a1, 5b1, 5c1, 5d1, 5a2, 5b2, 5c2, and 5d2, and the sensitivity directions of all magnetic induction units 5 are the positive Y-axis direction, wherein the vertical projections of magnetic induction units 5a1, 5b1, 5c1, and 5d1 are located at the air gaps of the magnetic flux path connection areas 4a, 4c, 4d, and 4f of the aforementioned magnetic flux conversion module 10, respectively, the magnetic induction units 5a2, 5b2, 5c2, and 5d2 are located within the vertical projection range of the soft magnetic metal material of the magnetic flux conversion module 10, and as magnetic shielding reference magnetic induction units, the magnetic shielding reference magnetic induction units are distributed adjacent to the magnetic induction units at the air gap projection, and are all located near the air gaps of the magnetic flux path connection areas. The magnetic field induction direction is the X-axis direction, and the soft magnetic metal material constituting the magnetic flux conversion module 10 is distributed in the XY plane, which is described by taking the magnetic field to be measured being in the positive X-axis direction as an example; in this case, the magnetic field input area 1 is located at the end of the negative X-axis direction. The magnetic field output area 2 is located at the end of the positive X-axis direction; the magnetic flux direction conversion area 3a comprises three ports pointing to the negative X-axis direction, the positive Y-axis direction, and the negative Y-axis direction, the magnetic flux direction conversion area 3b is a corner pointing to the positive X-axis direction and the negative Y-axis direction, the magnetic flux direction conversion area 3c is a corner pointing to the negative X-axis direction and the negative Y-axis direction, the magnetic flux direction conversion area 3d comprises three ports pointing to the positive X-axis direction, the positive Y-axis direction, and the negative Y-axis direction, the magnetic flux direction conversion area 3e is a corner pointing to the positive X-axis direction and the positive Y-axis direction, and the magnetic flux direction conversion area 3f is a corner pointing to the negative X-axis direction and the positive Y-axis direction. The magnetic flux path connection area 4a connects to the magnetic flux direction conversion areas 3a and 3b in the Y-axis direction, the magnetic flux path connection area 4b connects to the magnetic flux direction conversion areas 3b and 3c in the X-axis direction, the magnetic flux path connection area 4c connects to the magnetic flux direction conversion areas 3c and 3d in the Y-axis direction, the magnetic flux path connection area 4d connects to the magnetic flux direction conversion areas 3a and 3e in the Y-axis direction, the magnetic flux path connection area 4e connects to the magnetic flux direction conversion areas 3e and 3f in the X-axis direction, and the magnetic flux path connection area 4f connects to the magnetic flux direction conversion areas 3d and 3f in the Y-axis direction; and among them, the magnetic flux path connection areas 4a, 4c, 4d, and 4f are each provided with two air gaps in the X-axis direction that penetrate the soft magnetic metal material.

When the magnetic field to be measured is in the positive X-axis direction, the soft magnetic metal material concentrates and amplifies the magnetic field to be measured and enters the magnetic field input area 1, and then is divided into two sides at the magnetic flux direction conversion area 3a and twisted to the positive Y-axis direction and the negative Y-axis direction to form two magnetic flux paths connected in parallel. One of the magnetic circuits passes through the magnetic flux path connection area 4a with an air gap along the positive Y-axis direction and generates a magnetic field component in the positive Y-axis direction in the air gap, then passes through the magnetic flux direction conversion area 3b, the magnetic flux path connection area 4b, and the magnetic flux direction conversion area 3c in sequence, and after the magnetic path is twisted reversely from the positive Y-axis direction to the negative Y-axis direction, it then passes through the magnetic flux path connection area 4c with an air gap and generates a magnetic field component in the negative Y-axis direction in the air gap. The other magnetic path passes through the magnetic flux path connection area 4d with an air gap along the negative Y-axis direction, and generates a magnetic field component in the negative Y-axis direction in the air gap; this magnetic path then passes through the magnetic flux direction conversion area 3e, the magnetic flux path connection area 4e, and the magnetic flux direction conversion area 3f in sequence, and after the magnetic path is twisted reversely from the negative Y-axis direction to the positive Y-axis direction, it then passes through the magnetic flux path connection area 4f with an air gap, and generates a magnetic field component in the positive Y-axis direction in the air gap; finally, the two magnetic paths enter the magnetic flux path conversion area 3d from the magnetic flux path connection area 4c along the negative Y-axis direction and from the magnetic flux path connection area 4f along the positive Y-axis direction, respectively, then are twisted back to the positive X-axis direction, and subsequently pass through the magnetic field output area 2. Similarly, by taking the magnetic field to be measured being in the positive X-axis as an example, one of the magnetic circuits that have been concentrated and amplified passes through the magnetic flux path connection area 4a with an air gap along the positive Y-axis direction, and then passes through the magnetic flux path connection area 4c with an air gap along the negative Y-axis direction; the other magnetic circuit passes through the magnetic flux path connection area 4d with an air gap along the negative Y-axis direction, and then passes through the magnetic flux path connection area 4f with an air gap along the positive Y-axis direction; at this moment, a magnetic field component in the positive Y-axis direction is generated in the air gaps of the magnetic flux path connection areas 4a and 4f, and a magnetic field component in the negative Y-axis direction is generated in the air gaps of the magnetic flux path connection areas 4c and 4d. Since the sensitivity directions of the magnetic induction units 5a, 5b, 5c, 5d are all in the positive Y-axis direction, the resistance values of the magnetic induction units 5a and 5d decrease, while the resistance values of the magnetic induction units 5b and 5c increase. Since the magnetic induction units 5a2, 5b2, 5c2, and 5d2 serve as magnetic shielding reference magnetic induction units, and are located within the vertical projection range of the soft magnetic metal material of the magnetic flux conversion module 10, their resistance values are considered to be approximately constant. Therefore, the series and parallel magnetic induction units 5a1, 5b1, 5c1, and 5d1 can be selected to form a push-pull half-bridge or push-pull full-bridge structure. Alternatively, the magnetic induction units 5a1, 5b1, 5c1, and 5d1 can also be selected to form, with the magnetic induction units 5a2, 5b2, 5c2, and 5d2 or a reference resistor with a fixed resistance value, a differential half-bridge or differential full-bridge structure to sense a magnetic field in the positive X-axis direction and generate a differential voltage signal. An open-loop signal conditioning circuit may be employed to perform conditioning amplification, temperature compensation, and linearity correction on the differential voltage signal to form an output electrical signal of the magnetic field sensor 01.

Optionally, FIG. 9 shows a schematic diagram of another structure of the magnetic flux conversion module 10 and its magnetic field sensor 01, which is equivalent to symmetrically dividing the soft magnetic metal material structure of the magnetic flux conversion module 10 in FIG. 8 along the X-axis and translating and exchanging it in the Y-axis direction. At the same time, it can also be regarded as translating and connecting the structures of the magnetic flux conversion modules 10 on the side of the positive Y-axis direction and the side of the negative Y-axis direction in FIG. 7. The original magnetic field input area 1 and magnetic field output area 2 are symmetrically divided into magnetic field input areas 1a and 1b and magnetic field output areas 2a and 2b, and moreover, the original magnetic flux direction conversion areas 3b and 3h are merged, the magnetic flux path connection areas 4b and 4e are merged, and the magnetic flux direction conversion areas 3c and 3g are merged. Its measurement principle is basically the same as the structure shown in FIG. 7, except that the soft magnetic materials on both sides of the Y-axis are close and merged, so its measurement principle will not be described in detail. Assuming the magnetic field to be measured is in the positive X-axis direction, the magnetic circuit on the side of the positive Y-axis direction passes sequentially through the magnetic field input area 1a, the magnetic flux direction conversion area 3a, the magnetic flux path connection area 4a, the magnetic flux direction conversion area 3b, the magnetic flux path connection area 4b, the magnetic flux direction conversion area 3c, the magnetic flux path connection area 4c, the magnetic flux direction conversion area 3d, and the magnetic field output area 2a; the magnetic circuit on the side of the negative Y-axis direction passes sequentially through the magnetic field input area 1b, the magnetic flux direction conversion area 3e, the magnetic flux path connection area 4d, the magnetic flux direction conversion area 3b, the magnetic flux path connection area 4b, the magnetic flux direction conversion area 3c, the magnetic flux path connection area 4e, the magnetic flux direction conversion area 3f, and the magnetic field output area 2b; and the vertical projections of the magnetic induction units 5a, 5b, 5c, and 5d are located at the air gaps of the magnetic flux path connection areas 4a, 4c, 4d, and 4e, respectively.

By partially merging separate soft magnetic metal materials where the two parallel magnetic circuits are at, it is helpful to improve stability and reduce volume. Meanwhile, a magnetic induction unit located within the vertical projection range of the soft magnetic metal material of the magnetic flux conversion module 10 is added as a magnetic shielding reference magnetic induction unit, which can form a differential half-bridge or differential full-bridge structure to sense the magnetic field to be measured, and help to adjust and expand the measurement range of the magnetic field sensor 01. Among them, the magnetic shielding reference magnetic induction unit and the magnetic induction unit at the air gap projection are distributed adjacently and are both located near the air gap in the magnetic flux path connection area, which helps to enhance consistency and reduce zero-point drift.

In one embodiment, the magnetic flux conversion module 10 further comprises: a magnetic flux shielding soft magnetic path; the magnetic flux shielding soft magnetic path connects two magnetic flux path connection areas that are arranged opposite each other along the magnetic induction direction among the at least four magnetic flux path connection areas; and the magnetic flux shielding soft magnetic path is used to perform shielding or flux separation on the magnetic flux path connection areas with air gaps.

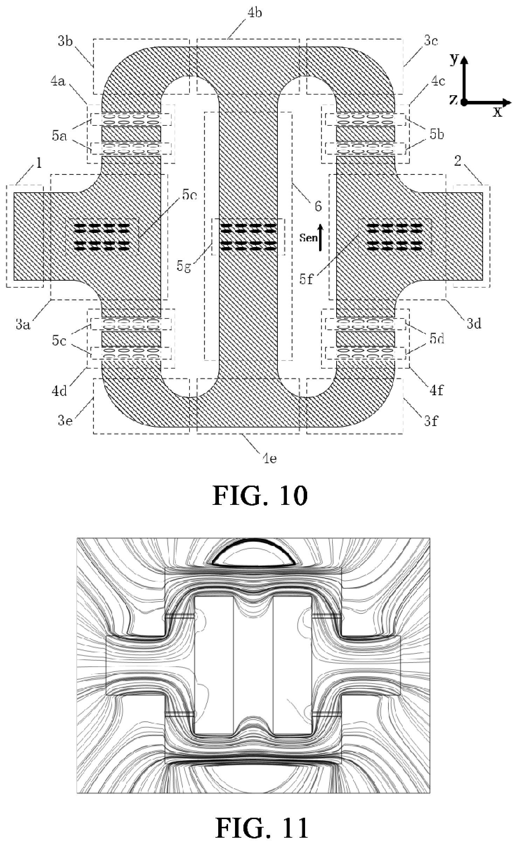

For example, as shown in FIG. 10, the magnetic field sensor 01 comprises a magnetic flux conversion module 10, a magnetic induction module 20, and a differential detection module 30, and the magnetic field induction direction of the magnetic field sensor 01 is the same as that of the magnetic flux conversion module 10, which is the X-axis direction. The magnetic flux conversion module 10 is a single-plane single magnetic field induction direction, which can comprise: one magnetic field input area 1, one magnetic field output area 2, six magnetic flux direction conversion areas 3a, 3b, 3c, 3d, 3e, 3f, six magnetic flux path connection areas 4a, 4b, 4c, 4d, 4e, 4f, and one magnetic flux shielding soft magnetic path 6. The magnetic induction module 20 may comprise magnetic induction units 5a, 5b, 5c, 5d, 5e, 5f, 5g, and the sensitivity directions of all magnetic induction units 5 are the positive Y-axis direction, wherein the vertical projections of magnetic induction units 5a, 5b, 5c, and 5d are located at the air gaps of the magnetic flux path connection areas 4a, 4c, 4d, and 4f of the aforementioned magnetic flux conversion module 10, respectively, the magnetic induction units 5e, 5f, and 5g are located within the vertical projection range of the soft magnetic metal material of the magnetic flux conversion module 10, and as magnetic shielding reference magnetic induction units, they are respectively arranged at the magnetic flux direction conversion areas 3a and 3d and the magnetic flux shielding soft magnetic path 6, and the magnetic induction units serving as magnetic shielding reference magnetic induction units are no longer distributed adjacent to the magnetic induction units at the air gap projections. Instead, they are located at a position with a large coverage area of soft magnetic metal materials. The magnetic field induction direction is the X-axis direction, and the soft magnetic metal material constituting the magnetic flux conversion module 10 is distributed in the XY plane, which is described by taking the magnetic field to be measured being in the positive X-axis direction as an example; in this case, the magnetic field input area 1 is located at the end of the negative X-axis direction, and the magnetic field output area 2 is located at the end of the positive X-axis direction; the magnetic flux direction conversion area 3a comprises three ports pointing to the negative X-axis direction, the positive Y-axis direction, and the negative Y-axis direction, the magnetic flux direction conversion area 3b is a corner pointing to the positive X-axis direction and the negative Y-axis direction, the magnetic flux direction conversion area 3c is a corner pointing to the negative X-axis direction and the negative Y-axis direction, the magnetic flux direction conversion area 3d comprises three ports pointing to the positive X-axis direction, the positive Y-axis direction, and the negative Y-axis direction, the magnetic flux direction conversion area 3e is a corner pointing to the positive X-axis direction and the positive Y-axis direction, and the magnetic flux direction conversion area 3f is a corner pointing to the negative X-axis direction and the positive Y-axis direction. The magnetic flux path connection area 4a connects to the magnetic flux direction conversion areas 3a and 3b in the Y-axis direction, the magnetic flux path connection area 4b comprises three ports pointing to the positive X-axis direction, the negative X-axis direction, and the negative Y-axis direction, the magnetic flux path connection area 4c connects to the magnetic flux path connection areas 4b and 3d in the Y-axis direction, the magnetic flux path connection area 4d connects to the magnetic flux direction conversion areas 3a and 3e in the Y-axis direction, the magnetic flux path connection area 4e comprises three ports pointing to the positive X-axis direction, the negative X-axis direction, and the positive Y-axis direction, and the magnetic flux path connection area 4f connects to the magnetic flux direction conversion areas 3d and 3f in the Y-axis direction; the magnetic flux shielding soft magnetic path 6 connects to the magnetic flux path connection areas 4b and 4e in the Y-axis direction, and the magnetic flux path connection areas 4a, 4c, 4d, and 4f are each provided with two air gaps in the X-axis direction that penetrate the soft magnetic metal material.

As shown in FIG. 11, from the simulation diagram of a magnetic flux path after a magnetic field to be measured in the positive X-axis direction is applied to the magnetic flux conversion module 10 in the embodiment of FIG. 10, it can be seen that the magnetic field to be measured is concentrated and amplified by the soft magnetic metal material to form a magnetic circuit, and is divided into two sides and twisted to the positive Y-axis direction and the negative Y-axis direction to form two parallel magnetic flux paths; subsequently, the two magnetic circuits are respectively twisted in opposite directions in the Y-axis direction and then twisted back to the positive X-axis direction. It can be seen that the magnetic field to be measured can generate an obvious magnetic field component in the positive Y-axis direction at the air gaps in the magnetic flux path connection areas 4a and 4f, and can generate an obvious magnetic field component in the negative Y-axis direction at the air gaps in the magnetic flux path connection areas 4c and 4d, thereby enabling the formation of a differential magnetic field, and the magnetic flux paths through the air gaps are two magnetic flux paths connected in parallel that are mirror-symmetrical about the X-axis. When the magnetic field to be measured is in the positive Y-axis direction, the magnetic flux shielding soft magnetic path 6 can concentrate and guide the magnetic field in the Y-axis direction, thereby achieving the shielding or flux separation effect on the magnetic flux path connection areas with air gaps.

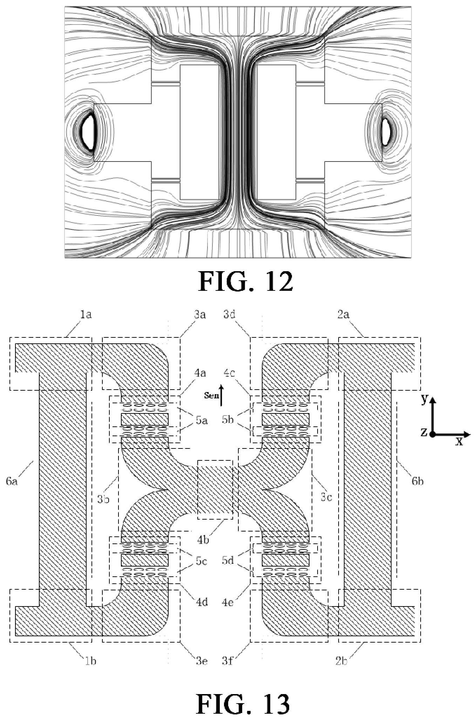

As shown in FIG. 12, from the simulation diagram of a magnetic flux path after a magnetic field to be measured in the positive Y-axis direction is applied to the magnetic flux conversion module 10 in the embodiment of FIG. 10, it can be seen that a majority of the magnetic field to be measured in the Y-axis direction forms a magnetic circuit in the Y-axis direction along the magnetic flux shielding soft magnetic path 6, which forms shielding or flux separation for the magnetic flux path connection areas with air gaps. Similarly, by taking the magnetic field to be measured being in the positive X-axis as an example, a magnetic field component in the positive Y-axis direction is generated in the air gaps of the magnetic flux path connection areas 4a and 4f, and a magnetic field component in the negative Y-axis direction is generated in the air gaps of the magnetic flux path connection areas 4c and 4d. Since the sensitivity directions of the magnetic induction units 5a, 5b, 5c, 5d are all in the positive Y-axis direction, the resistance values of the magnetic induction units 5a and 5d decrease, while the resistance values of the magnetic induction units 5b and 5c increase. Since the magnetic induction units 5e, 5f, and 5g serve as magnetic shielding reference magnetic induction units, and are located within the vertical projection range of the soft magnetic metal material of the magnetic flux conversion module 10, their resistance values are considered to be approximately constant. Therefore, the series and parallel magnetic induction units 5a, 5b, 5c, and 5d can be selected to form a push-pull half-bridge or push-pull full-bridge structure. Alternatively, the magnetic induction units 5a, 5b, 5c, and 5d can also be selected to form, with the magnetic induction units 5e, 5f, and 5g or a reference resistor with a fixed resistance value, a differential half-bridge or differential full-bridge structure to sense a magnetic field in the positive X-axis direction and generate a differential voltage signal. An open-loop signal conditioning circuit may be employed to perform conditioning amplification, temperature compensation, and linearity correction on the differential voltage signal to form an output electrical signal of the magnetic field sensor 01. The magnetic field sensor 01 may also comprise a substrate, lead pads, and a mechanical support housing, the fabrication process used is single-chip integration, and the magnetic induction unit 5 used is a magnetoresistive sensitive element with the sensitivity direction parallel to its own plane, with tunnel magnetoresistive (TMR) as an example.

By adding a magnetic flux shielding soft magnetic path, the influence of the magnetic field to be measured on the operating range of the magnetic field sensor 01 is addressed, which significantly increases the operating range of the magnetic field sensor under the magnetic field to be measured, and improves the sensitivity consistency of the magnetic induction unit. Meanwhile, the magnetic induction unit that serves as the magnetic shielding reference magnetic induction unit is no longer distributed adjacent to the magnetic induction unit at the air gap projection. Instead, it is located at a position with a large coverage area of soft magnetic material, which increases the magnetic shielding effect and makes its resistance value more stable.

In one embodiment, the magnetic flux conversion module 10 comprises: at least two magnetic field input areas and at least two magnetic field output areas; the magnetic flux shielding soft magnetic path connects two adjacent magnetic field input areas of the at least two magnetic field input areas, and the magnetic flux shielding soft magnetic path connects two adjacent magnetic field output areas of the at least two magnetic field output areas; and the magnetic flux shielding soft magnetic path is used to perform shielding or flux separation on the magnetic flux path connection areas with air gaps.

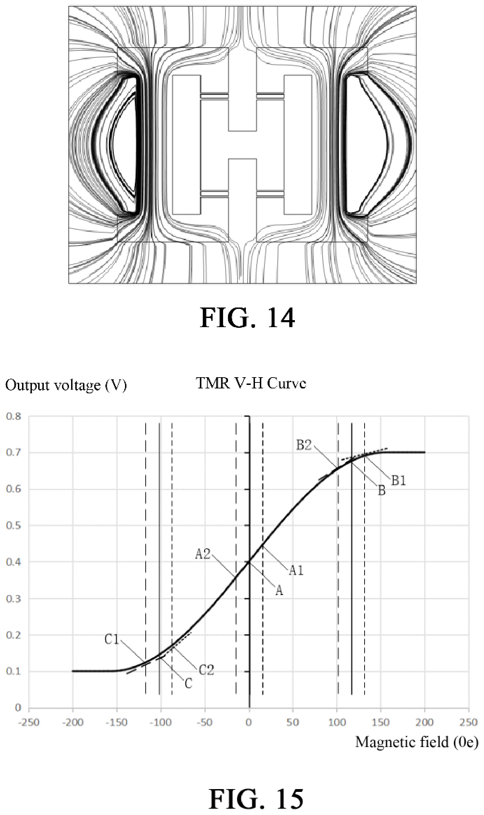

For example, as shown in FIG. 13, this structure can, based on the magnetic flux conversion module 10 in FIG. 9, use a soft magnetic metal material to connect the magnetic field input areas 1a and 1b along the Y-axis direction to form a magnetic flux shielding soft magnetic path 6a, and to connect the magnetic field output areas 2a and 2b to form a magnetic flux shielding soft magnetic path 6b at the end of the negative X-axis direction and the end of the positive X-axis direction, respectively; thus, the magnetic field input area 1a and the magnetic field output area 2a contain three ports pointing to the positive X-axis direction, the negative X-axis direction, and the negative Y-axis direction, and the magnetic field input area 1b and the magnetic field output area 2b contain three ports pointing to the positive X-axis direction, the negative X-axis direction, and the positive Y-axis direction. As shown in FIG. 14, from the simulation diagram of a magnetic flux path after a magnetic field to be measured in the positive Y-axis direction is applied to the magnetic flux conversion module 10 in the embodiment of FIG. 13, it can be seen that a majority of the magnetic field to be measured in the Y-axis direction forms a magnetic circuit in the Y-axis direction along the magnetic flux shielding soft magnetic paths 6a and 6b, which forms shielding or flux separation for the magnetic flux path connection areas with air gaps. Specifically, for the magnetic field to be measured in the magnetic field induction direction (the X-axis direction in this embodiment), the magnetic flux conversion module 10 has been able to convert the magnetic field in the magnetic field induction direction into opposite magnetic field components in the positive and negative directions perpendicular to the magnetic field induction direction, to form a differential magnetic field, and then measure a magnetic induction unit with a sensitivity direction perpendicular to the magnetic field induction direction. In an ideal situation, since all magnetic induction units are considered to be affected by the same magnetic field to be measured perpendicular to the magnetic field induction direction, only the magnetic field to be measured in the magnetic field induction direction will be reflected in the output electrical signal. However, in actual measurements, this detection method may reduce the operating range of the magnetic field sensor 01. Specifically, tunnel magnetoresistance (TMR) is used as an example.

FIG. 15 is a schematic diagram of a voltage-magnetic field curve of tunnel magnetoresistance (TMR). It can be seen that there is a certain linear range on both sides of the zero point of the magnetic field, which can be regarded as the normal operating range of a single magnetic induction unit. When operating within the linear range, the sensitivity of TMR can be considered constant, leading to good sensitivity consistency. Assuming the TMR sensitivity direction is the Y-axis, if a magnetic field of 0 is applied to the magnetic field sensor 01 in FIG. 8, whose magnetic field induction direction is the X-axis, then the operating point of the magnetic induction unit is point A in FIG. 15. When a magnetic field to be measured in the X-axis direction is introduced, the magnetic flux conversion module 10 converts the magnetic field in the X-axis direction into opposite magnetic field components in the positive and negative directions of the Y-axis. That is, the operating point of the magnetic induction unit moves to A1 and A2 in FIG. 15, respectively. As long as A1 and A2 are in the linear range, it can be considered that all magnetic induction units have the same sensitivity. Therefore, when the Y-axis magnetic field is 0, the magnetic field measurement range in the X-axis direction can span the entire linear range. When the Y-axis magnetic field is not 0, the operating point of the magnetic induction unit moves from point A before the X-axis magnetic field is introduced. In order to maintain operation in the linear range, the magnetic field measurement range in the X-axis direction is reduced accordingly. In extreme cases, when the Y-axis magnetic field has moved the operating point to the nonlinear range of point B or point C, the sensitivity of the magnetic induction unit will no longer be constant regardless of how the X-axis magnetic field is reduced, and the sensitivity is no longer consistent. In order to avoid the influence of the Y-axis magnetic field on the operating range of the magnetic field sensor 01 under the above conditions, the magnetic flux shielding soft magnetic path 6 is introduced for the magnetic field sensor 01 of the magnetic flux conversion module 10 structure in FIG. 10 and FIG. 13, and it can be seen that a majority of the magnetic field to be measured in the Y-axis direction forms a magnetic circuit in the Y-axis direction along the magnetic flux shielding soft magnetic path 6, which forms shielding or flux separation for the magnetic flux path connection areas with air gaps, and greatly reduces the influence of the Y-axis magnetic field to be measured on the magnetic induction unit. The Y-axis magnetic field detected by the magnetic induction unit almost all comes from the distortion and transformation of the X-axis magnetic field by the magnetic flux conversion module 10. Therefore, even under a large Y-axis magnetic field to be measured, the operating point of the magnetic induction unit can still be located near the zero point (point A), which significantly increases the operating range of the magnetic field sensor 01 under the Y-axis magnetic field to be measured.

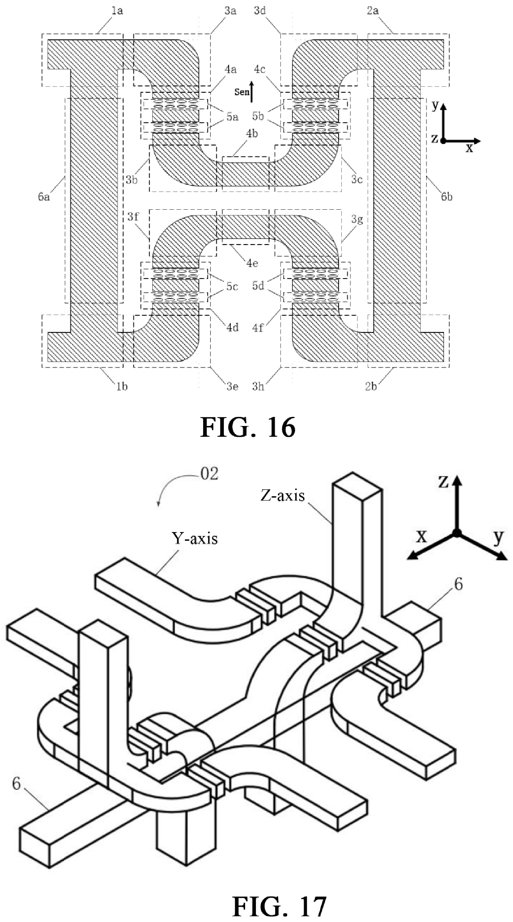

Optionally, FIG. 16 shows a schematic diagram of another structure of the magnetic flux conversion module 10 and its magnetic field sensor 01. Based on the magnetic flux conversion module 10 in FIG. 7, this structure uses a soft magnetic metal material to connect the magnetic field input areas 1a and 1b along the Y-axis direction to form a magnetic flux shielding soft magnetic path 6a, and connect the magnetic field output areas 2a and 2b to form a magnetic flux shielding soft magnetic path 6b at the end of the negative X-axis direction and the end of the positive X-axis direction, respectively. Thus, the magnetic field input area 1a and the magnetic field output area 2a contain three ports pointing to the positive X-axis direction, the negative X-axis direction, and the negative Y-axis direction, and the magnetic field input area 1b and the magnetic field output area 2b contain three ports pointing to the positive X-axis direction, the negative X-axis direction, and the positive Y-axis direction. A majority of the magnetic field to be measured in the Y-axis direction forms a magnetic circuit in the Y-axis direction along the magnetic flux shielding soft magnetic paths 6a and 6b, which forms shielding or flux separation for the magnetic flux path connection areas with air gaps.

By adding a magnetic flux shielding soft magnetic path, and increasing the distance between the soft magnetic materials at the location of the magnetic induction module 20, it can further enhance the isolation effect of the magnetic field to be measured and strengthen shielding or flux separation, which addresses the influence of the magnetic field to be measured on the operating range of the magnetic field sensor 01, significantly increases the operating range of the magnetic field sensor 01 under the magnetic field to be measured, and improves the sensitivity consistency of the magnetic induction module 20.

In one embodiment, the magnetic flux conversion module 10 and the magnetic induction module 20 are disposed on the same circuit chip using a chip integration process.

For example, the magnetic flux conversion module 10 and the magnetic induction module 20 may be located on the same circuit chip, the flux conversion module 10 is made of a soft magnetic metal material with high magnetic permeability, and the soft magnetic metal material is deposited on the substrate inside the circuit chip. In the magnetic flux conversion module 10 within the chip, the soft magnetic metal material deposited on the substrate forms one or two magnetic flux paths through the magnetic flux guiding effect, generates magnetic field components with opposite directions at air gaps at different locations, and forms a differential magnetic field, thereby enabling the formation of a push-pull bridge structure.

In this embodiment, the cost is reduced by using a single-chip integrated fabrication process to fabricate the magnetic flux conversion module 10 and the magnetic induction unit on the same chip.

In one embodiment, the soft magnetic materials of any two of the magnetic field input areas, the magnetic field output areas, the magnetic flux direction conversion areas, and the magnetic flux path connection areas are disposed on the same plane.

For example, the magnetic flux conversion module 10 and its magnetic field sensor 01 in the above embodiments are both single-plane single magnetic field induction direction, that is, the soft magnetic materials of the magnetic field input areas, the magnetic field output areas, the magnetic flux direction conversion areas, and the magnetic flux path connection areas are all provided on the same plane with the advantage being that only magnetic sensing units with the same sensitivity direction need to be used, and a single chip integrated fabrication process can be used. Meanwhile, in actual production, the requirements can be met if two of the soft magnetic materials in the magnetic field input areas, the magnetic field output areas, the magnetic flux direction conversion areas, and the magnetic flux path connection areas are provided on the same plane or not on the same plane. For the multi-axis magnetic field sensor 02 with multiple magnetic field induction directions, any magnetic field induction direction can adopt the structure of the aforementioned magnetic flux conversion module 10 and its magnetic field sensor 01 with single-plane single magnetic field induction direction, and then they are combined. By disposing soft magnetic materials of any two parts in the magnetic flux conversion module 10 that constitute the magnetic flux path on the same plane, the technical difficulty is reduced and the needs of more scenarios can be met.

In one embodiment, the differential detection module 30 comprises: an open-loop signal conditioning circuit; the open-loop signal conditioning circuit is electrically connected with the magnetic induction units; and the open-loop signal conditioning circuit is used to perform conditioning amplification, and/or temperature compensation, and/or linearity correction on the differential voltage signal.

For example, the magnetic induction unit can employ a variety of sensitive elements depending on the placement and orientation. Specifically, when the sensitivity direction of the magnetic induction unit is perpendicular to its own plane, the substrate where the magnetic induction unit is located is perpendicular to the plane in which the magnetic flux conversion module 10 is located. For example, if the magnetic flux conversion module 10 located in the YZ plane is measured by using Hall elements, the substrate of each Hall element is respectively parallel to the XZ plane, and then basic components, such as substrates, lead pads, mechanical support housing, etc., together with the magnetic induction module 20, form the magnetic field sensor 01, wherein the open-loop signal conditioning circuit is disposed on the substrate. The open-loop signal conditioning circuit is used to perform conditioning amplification, temperature compensation, and linearity correction on the differential voltage signal to form an output electrical signal of the current sensor. When the sensitivity direction of the magnetic induction unit is parallel to its own plane, the substrate in which it is located is parallel to the plane in which the magnetic flux conversion module 10 is located. Since all magnetic induction units can form a differential bridge or push-pull bridge using only the sensitivity in the same direction, when a magnetic induction unit with the sensitivity direction parallel to its own plane, such as tunnel magnetoresistive (TMR), is employed, a single-step fabrication can be achieved, and it can form, together with the magnetic flux conversion module 10 and the open-loop signal conditioning circuit, the magnetic field sensor 01. An open-loop signal conditioning circuit is used for conditioning amplification, temperature compensation, and linearity correction, thereby achieving open-loop detection, improving detection accuracy, and obtaining good linearity.

In one embodiment, the differential detection module 30 comprises: a closed-loop signal conditioning circuit and a magnetic field feedback coil; the closed-loop signal conditioning circuit is electrically connected to the magnetic induction units; the closed-loop signal conditioning circuit, the magnetic field feedback coil, and the magnetic induction units constitute a closed-loop magnetic field feedback structure; the closed-loop signal conditioning circuit is used to condition and amplify the differential voltage signal; the magnetic field feedback coil is used to generate a feedback magnetic field based on the conditioned and amplified signal to achieve dynamic magnetic field balance, and to sample the current in the magnetic field feedback coil to form the electrical signal to be measured.

For example, the differential detection module 30, as an output, may employ a closed-loop signal conditioning circuit and a magnetic field feedback coil, wherein the closed-loop signal conditioning circuit, the magnetic field feedback coil, and the magnetic induction units constitute a closed-loop magnetic field feedback structure; after the closed-loop signal conditioning circuit conditions and amplifies the differential voltage signal, the magnetic field feedback coil generates a feedback magnetic field to achieve dynamic magnetic field balance; and the current in the magnetic field feedback coil is sampled to form the output electrical signal to be measured of the magnetic field sensor 01. The magnetic field feedback coil can be wound and disposed outside the magnetic flux conversion module 10, or it can be integrated inside a magnetic induction unit. The magnetic field sensor 01 may also comprise a substrate, lead pads, and a mechanical support housing, the fabrication process used is single-chip integration, and the magnetic induction unit used is a magnetoresistive sensitive element with the sensitivity direction parallel to its own plane, with giant magnetoresistance (GMR) as an example. A closed-loop signal conditioning circuit and a magnetic field feedback coil are used for differential detection, thereby achieving closed-loop negative feedback, improving accuracy, and obtaining good linearity.

Refer to FIG. 17, which is a schematic diagram of the structure of a multi-axis magnetic field sensor 02 according to the embodiments of the present application,. The sensor comprises: a plurality of combined magnetic field sensors 01 from the above embodiments; the magnetic flux conversion module 10 in the plurality of combined magnetic field sensors 01 has a plurality of magnetic field induction directions; and the magnetic flux conversion module 10 is used to perform differential detection on the corresponding magnetic field to be measured in any of the magnetic field induction directions.

For example, the magnetic flux conversion module 10 and its magnetic field sensor 01 above are both single-plane single magnetic field induction direction, while for the multi-axis magnetic field sensor 02 with multiple magnetic field induction directions, any magnetic field induction direction can adopt the structure of the aforementioned magnetic flux conversion module 10 and its magnetic field sensor 01 with single-plane single magnetic field induction direction, and then they are combined. Optionally, as shown in FIG. 17, which is a schematic diagram of the structure of the dual-axis magnetic field sensor 01 with dual magnetic field induction directions of Y-axis and Z-axis, the magnetic flux conversion module 10 in the Y-axis magnetic field induction direction adopts a structure similar to the magnetic flux conversion module 10 in FIG. 5, and its magnetic induction module 20 can be a magnetic induction unit located in the XY plane with the sensitivity direction located in the positive X-axis direction of the XY plane, thereby forming a push-pull full bridge structure. On the other hand, the magnetic flux conversion module 10 in the Z-axis magnetic field induction direction adopts a structure of the magnetic flux conversion module 10 that one half of the magnetic flux conversion module 10 in the Y-axis magnetic field induction direction is cut off along the X-axis, and its magnetic induction module 20 can be a magnetic induction unit located in the XY plane with the sensitivity direction located in the positive X-axis direction of the XY plane, thereby forming a push-pull half bridge structure. Since the sensitivity directions of all magnetic induction units are the positive X-axis direction, a magnetic flux shielding soft magnetic path 6 is added in the X-axis direction to perform shielding or flux separation on the magnetic field to be measured in the X-axis direction. The magnetic flux conversion module 10 and its magnetic field sensor 01 not only can measure the dual magnetic field induction directions of the Y-axis and Z-axis, but also can achieve push-pull bridge measurement of two magnetic field induction directions using only magnetic induction units with the same sensitivity direction, which can realize the single-step fabrication of magnetic induction units, avoid the angle deviation and zero-point offset problems caused by using different sensitivity directions in the prior art, and achieve good sensitivity consistency and high measurement accuracy.

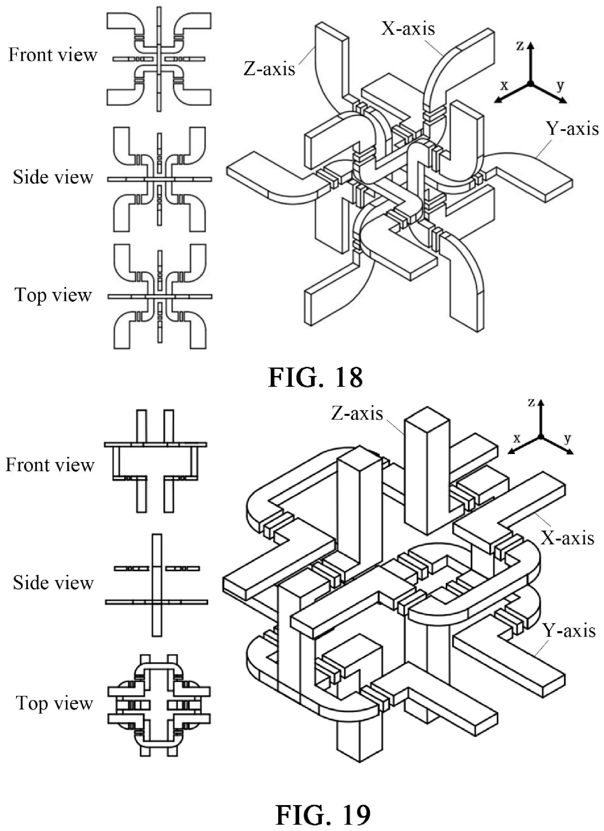

Optionally, structural schematic diagrams and three views of two types of magnetic flux conversion module 10 and its magnetic field sensor 01 with XYZ three-axis magnetic field induction directions are shown in FIG. 18 and FIG. 19. The structure shown in FIG. 18 illustrates one of the magnetic flux conversion modules 10 and magnetic field sensors 01 thereof with all three XYZ axes adopting a structure similar to that of the magnetic flux conversion module 10 in FIG. 7 that are then combined; and the structure shown in FIG. 19 illustrates one of the magnetic flux conversion modules 10 and magnetic field sensors 01 thereof with all three XYZ axes adopting a structure similar to that of the magnetic flux conversion module 10 in FIG. 5 in Embodiment II that are then combined For the two structures above, the magnetic induction units in any magnetic field induction direction are located on different planes. Therefore, different types of magnetic induction modules 20 and bridge structures can be selected according to the actual situation to realize the measurement of the three XYZ axes, respectively.

By setting up a multi-axis sensor, not only can respective magnetic induction modules 20 and measurement methods of multi-axis directions be flexibly and independently selected, but also the magnetic flux conversion module 10 in any direction has the functions of concentration and amplification and magnetic circuit guiding on the magnetic field to be measured in its own magnetic field induction direction. Therefore, it can perform shielding or flux separation on the magnetic induction modules 20 in other magnetic field induction directions, which can increase the operating range of the magnetic field sensor 01 and improve its flexibility.

The above description is merely embodiments of the present application and is not intended to limit the scope of protection of the present application. For those skilled in the art, the present application can have various modifications and variations. Any modifications, equivalent substitutions, and improvements made within the spirit and principles of the present application shall be encompassed within the scope of protection of the present application.

## Claims

1. A magnetic field sensor, **characterized in that** the sensor comprises:
a magnetic flux conversion module,
a magnetic induction module, and
a differential detection module; the differential detection module is electrically connected
to the magnetic induction module;
the magnetic flux conversion module comprises: a magnetic field input area, a magnetic field output area, a magnetic flux direction conversion area, and a magnetic flux path connection area; the magnetic flux path connection area comprises: at least two air gaps located at different positions; the magnetic induction module comprises: at least two magnetic induction units;
the magnetic flux path connection area carries out magnetic path connection on the magnetic field input area, the magnetic field output area, and the magnetic flux direction conversion area, and forms a magnetic flux path that, in the magnetic induction direction, enters the magnetic field input area, exits from the magnetic field output area, and is continuous; the at least two magnetic induction units are correspondingly arranged at the at least two air gaps, and the sensitivity direction of the magnetic induction unit is perpendicular to the vertical projection direction of the air gap;
wherein the magnetic flux conversion module is used to guide the magnetic field to be measured along the magnetic induction direction to the magnetic flux path and generate a differential magnetic field component in the air gap of the magnetic flux path; the magnetic induction module is used to generate a differential voltage signal based on the differential magnetic field component; and the differential detection module is used to process the differential voltage signal and output an electrical signal to be measured.

2. The sensor according to claim 1, **characterized in that** the magnetic flux conversion module comprises: a magnetic field input area, a magnetic field output area, at least three magnetic flux direction conversion areas, and at least two magnetic flux path connection areas;
the at least three magnetic flux direction conversion areas are located in corner areas of the magnetic flux conversion module, and the at least two magnetic flux path connection areas connect adjacent two of the corner areas and form a single continuous magnetic flux path in the magnetic induction direction with the magnetic field input area and the magnetic field output area;
wherein the at least two magnetic induction units are used to form a magnetoresistor of a push-pull half-bridge or push-pull full-bridge circuit, and generate a differential voltage signal by sensing the magnetic field to be measured in the magnetic induction direction.

3. The sensor according to claim 1, **characterized in that** the magnetic flux conversion module comprises: a magnetic field input area, a magnetic field output area, at least four magnetic flux direction conversion areas, and at least four magnetic flux path connection areas;
the at least four magnetic flux direction conversion areas are located in corner areas of the magnetic flux conversion module, and the at least four magnetic flux path connection areas connect adjacent two of the corner areas and form two continuous magnetic flux paths with the magnetic field input area and the magnetic field output area in the magnetic induction direction;
wherein the at least two magnetic induction units are used to form a magnetoresistor of a push-pull half-bridge or push-pull full-bridge circuit, and generate a differential voltage signal by sensing the magnetic field to be measured in the magnetic induction direction.

4. The sensor according to claim 3, **characterized in that** the magnetic induction module further comprises: a magnetic shielding reference magnetic induction unit; the magnetic shielding reference magnetic induction unit located within the vertical projection range of the magnetic flux conversion module;
wherein the at least two magnetic induction units are used to form a magnetoresistor of a push-pull half-bridge or push-pull full-bridge circuit, and generate a differential voltage signal by sensing the magnetic field to be measured in the magnetic induction direction; or
the at least one magnetic induction unit is used to form a magnetoresistor of a push-pull half-bridge or push-pull full-bridge circuit with the magnetic shielding reference magnetic induction unit, and generate a differential voltage signal by sensing the magnetic field to be measured in the magnetic induction direction.

5. The sensor according to claim 3, **characterized in that** the magnetic flux conversion module further comprises: a magnetic flux shielding soft magnetic path;
the magnetic flux shielding soft magnetic path connects two magnetic flux path connection areas that are arranged opposite each other along the magnetic induction direction among the at least four magnetic flux path connection areas; and the magnetic flux shielding soft magnetic path is used to perform shielding or flux separation on the magnetic flux path connection areas with air gaps.

6. The sensor according to claim 5, **characterized in that** the magnetic flux conversion module comprises: at least two magnetic field input areas and at least two magnetic field output areas;
the magnetic flux shielding soft magnetic path connects two adjacent magnetic field input areas of the at least two magnetic field input areas, and the magnetic flux shielding soft magnetic path connects two adjacent magnetic field output areas of the at least two magnetic field output areas; and the magnetic flux shielding soft magnetic path is used to shield or separate the magnetic flux path connection areas with air gaps.

7. The sensor according to any one of claims 1-6, **characterized in that** the magnetic flux conversion module and the magnetic induction module are disposed on the same circuit chip using a chip integration process.

8. The sensor according to any one of claims 1-6, **characterized in that** the soft magnetic materials of any two of the magnetic field input areas, the magnetic field output areas, the magnetic flux direction conversion areas, and the magnetic flux path connection areas are disposed on the same plane.

9. The sensor according to any one of claims 1-6, **characterized in that** the differential detection module comprises: an open-loop signal conditioning circuit; the open-loop signal conditioning circuit is electrically connected with the magnetic induction units; and the open-loop signal conditioning circuit is used to perform conditioning amplification, and/or temperature compensation, and/or linearity correction on the differential voltage signal.

10. The sensor according to any one of claims 1-6, **characterized in that** the differential detection module comprises: a closed-loop signal conditioning circuit and a magnetic field feedback coil;
the closed-loop signal conditioning circuit is electrically connected to the magnetic induction units; the closed-loop signal conditioning circuit, the magnetic field feedback coil, and the magnetic induction units constitute a closed-loop magnetic field feedback structure;
the closed-loop signal conditioning circuit is used to condition and amplify the differential voltage signal; the magnetic field feedback coil is used to generate a feedback magnetic field based on the conditioned and amplified signal to achieve dynamic magnetic field balance, and to sample the current in the magnetic field feedback coil to form the electrical signal to be measured.

11. A multi-axis magnetic field sensor, **characterized in that** the sensor comprises: a plurality of combined magnetic field sensors according to any one of claims 1-10;
the magnetic flux conversion module in the plurality of combined magnetic field sensors according to any one of claims 1-10 has a plurality of magnetic field induction directions;
and the magnetic flux conversion module is used to perform differential detection on the corresponding magnetic field to be measured in any of the magnetic field induction directions.
